# EUROPEAN PATENT APPLICATION

(11) **EP 4 791 162 A1**
(43) Date of publication of application: **12.08.2026**
(21) Application number: 24874931.9
(22) Date of filing: 01.10.2024
(51) Int. Cl.: H10K 59/80, H10K 59/131, H10K 59/12, H10K 71/00, H10K 71/60

(54) **ORGANIC LIGHT-EMITTING DISPLAY DEVICE**

(30) Priority: 06.10.2023 KR 20230133720; 30.09.2024 KR 20240132805
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/014917
(87) International publication number: WO 2025/075375

(57) **Abstract**

The organic light-emitting display device may include a plurality of anode electrodes in the plurality of subpixels, a plurality of organic light-emitting layers on the plurality of anode electrodes, a plurality of cathode electrodes on the plurality of organic light-emitting layers, a plurality of first banks between the plurality of subpixels in a second direction crossing a first direction, a plurality of first power wirings under the plurality of first banks along the first direction, a plurality of connection structures disposed in a plurality of first grooves of some first banks among the plurality of first banks, and a plurality of undercut structures on a lower side of some first banks in contact with the plurality of first grooves. The organic light-emitting layer and the cathode electrode may be disposed across some first banks, and the connection structure may electrically connect the cathode electrode to the first power wiring in the undercut structure.

## Description

### [Technical Field]

The embodiment relates to an organic light-emitting display device.

### [Background Art]

As the demand for portable information media increases, attempts to apply an organic light-emitting display device to various lightweight and thin information electronic devices are expanding. Recently, the organic light-emitting display device is being applied to product groups such as a mobile PC and an automobile rather than a TV or a mobile phone. Since the organic light-emitting display device applied to the mobile PC or the automobiles is driven as still image for a long time, long lifespan is required. In order to have the long lifespan, the extraction of light from the organic light-emitting element equipped in the organic light-emitting display device should be maximized. In addition, in order to reduce cost, it is necessary to expand the technology to enable the production of organic light-emitting diodes on the substrate of not only 8.5th generation (2200x2,500mm) but also 10.5th generation (3370x2940mm). In order to produce long-lifespan organic light-emitting elements, each subpixel with a top emission structure and a side-by-side structure must be implemented as a structure of an organic light-emitting element of two or more stacks.

The structure of such an organic light-emitting element may be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low PPA (pixel position accuracy) between the FMM and the substrate in a subpixel unit. Accordingly, the emission area ratio (EAR) is small, which limits the product lifespan. Here, EAR is the value obtained by dividing the emission area of a subpixel by the total area of the subpixel.

Therefore, the development of a new deposition method to solve the aforementioned problems and an organic light-emitting display device having a structure of a new organic light-emitting element using the new deposition method is very urgent.

### [Disclosure]

### [Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving the lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that can be understood through the description of the invention.

### [Technical Solution]

According to one aspect of the embodiment to achieve the above or other objects, an organic light-emitting display device, comprising: a plurality of subpixels having different colors along a first direction and having a same color along a second direction crossing the first direction; a plurality of anode electrodes on the plurality of subpixels; a plurality of organic light-emitting layers on the plurality of anode electrodes; a plurality of cathode electrodes on the plurality of organic light-emitting layers; a plurality of first banks between the plurality of subpixels along the second direction; a plurality of first power wirings under the plurality of first banks along the first direction; a plurality of connection structures disposed in a plurality of first grooves of some first banks among the plurality of first banks; and a plurality of undercut structures on a lower side of some first banks that contact the plurality of first grooves, wherein the organic light-emitting layer and the cathode electrode are disposed across some first banks, and wherein the connection structure is configured to electrically connect the cathode electrode to the first power wiring in the undercut structure.

The organic light-emitting display device may further comprise an interlayer-insulating layer under the first bank, the undercut structure may be formed such that a side portion of the interlayer-insulating layer in contact with the first groove is recessed from an inner side portion of the first bank toward a direction of an outer side.

The connection structure may comprise an auxiliary electrode extended from the first power wiring, the organic light-emitting layer may be cut off by the undercut structure so that some regions of the auxiliary electrode are exposed, and the cathode electrode may be in contact with some regions of the exposed auxiliary electrode in the undercut structure.

The organic light-emitting display device may comprise a plurality of inorganic insulating layers on the plurality of cathode electrodes; a plurality of second banks having second grooves disposed lengthwise along the second direction between the plurality of subpixels in the first direction; and a plurality of waterproof structures on the plurality of second banks, respectively.

The plurality of waterproof structures may comprise a first waterproof structure on the second bank; a second waterproof structure on a first side of the second groove of the second bank; and a third waterproof structure on a second side of the second groove of the second bank.

The first waterproof structure may be configured such that at least two of the plurality of inorganic insulating layers are overlapped on the second bank.

The second waterproof structure may be configured such that one of the plurality of inorganic insulating layers is formed in a curved shape by a first undercut structure, the third waterproof structure may be configured such that another of the plurality of inorganic insulating layers is formed in a curved shape by a second undercut structure, and the first undercut structure and the second undercut structure may be formed on a lower side of the second bank in contact with the second groove of the second bank.

The waterproof structure may surround at least one or more subpixel among the plurality of subpixels in the second direction.

The organic light-emitting display device may further comprise a plurality of second power wirings in a plurality of second grooves of a plurality of second banks along the second direction, and the at least two or more inorganic insulating layers may be disposed on a second power wiring.

The plurality of undercut structures may be positioned differently from each other in the plurality of first grooves.

The cathode electrode may comprise a first conductive layer; and a second conductive layer on the first conductive layer.

The organic light-emitting display device may further comprise an open structure in an edge region of at least one or more of the first bank and a second bank, and a hole injection layer or a charge generation layer of the organic light-emitting layer may be cut off by the open structure.

The organic light-emitting display device may further comprise a plurality of dummy subpixels having a stripe shape along the first direction in a non-display region; and a plurality of waterproof structures between the plurality of dummy subpixels in the second direction.

### [Advantageous Effects]

The effects of the organic light-emitting display device according to the embodiment are described as follows.

According to at least one of the embodiments, since there is no need to use an FMM, the process can be simplified and the process cost can be reduced.

According to at least one of the embodiments, since there is no need to use an FMM, the EAR in the subpixel can be increased, and the lifespan can be improved.

According to at least one of the embodiments, an organic light-emitting element may be deposited on a large-area substrate in an in-line deposition system, so that productivity, yield, and material utilization efficiency can be improved.

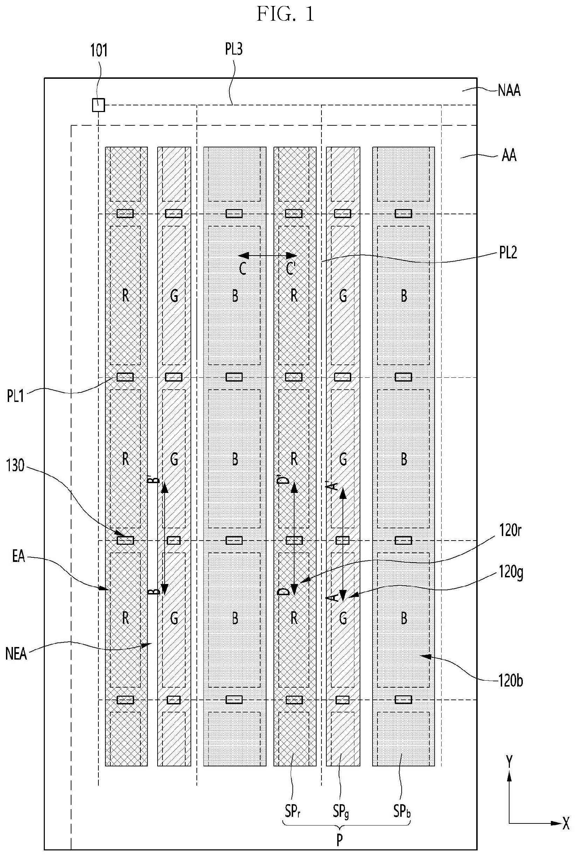

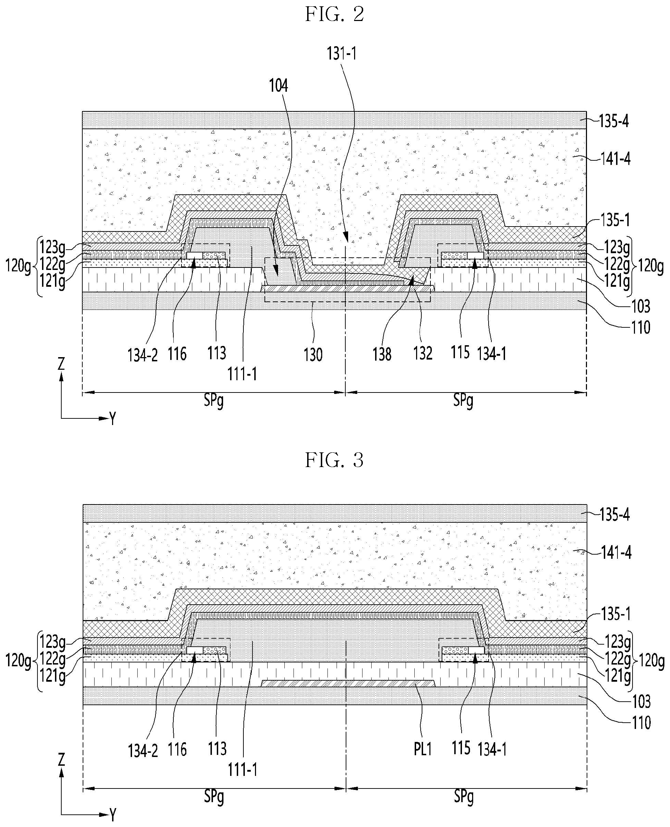

According to at least one of the embodiments, as illustrated in FIGS. 1 and 2 , a connection structure 130 may be disposed in a first groove 131-1 of a plurality of first banks 111-1 between a plurality of subpixels SPr, SPg, and SPb having the same color along the second direction Y. Accordingly, electrical connection between the cathode electrodes 123r, 123g and 123b of the plurality of subpixels SPr, SPg, and SPb and the first power wiring PL1 can be facilitated, and a disconnection defect can be prevented, so that operation defects or light-emitting defects of the subpixels SPr, SPg, and SPb can be prevented, thereby improving reliability.

According to at least one of the embodiments, as illustrated in FIGS. 1 to 4, a plurality of waterproof structures 143 to 145 may be disposed in each of the plurality of first banks 111-1 and/or the plurality of second banks 111-2. Accordingly, moisture, oxygen, etc. penetrating along the second direction Y may not penetrate into the plurality of subpixels SPr, SPg, and SPb, so that operation defects or light-emitting defects of the subpixels SPr, SPg, and SPb can be prevented, thereby improving reliability.

According to at least one of the embodiments, as illustrated in FIGS. 2 and 3, a hole injection layer, a charge generation layer, etc. of each of the plurality of subpixels SPr, SPg, and SPb may be cut off by the open structures 134-1 and 134-2, so that leakage current flowing to the hole injection layer, the charge generation layer, etc. can be blocked, and poor image quality can be prevented.

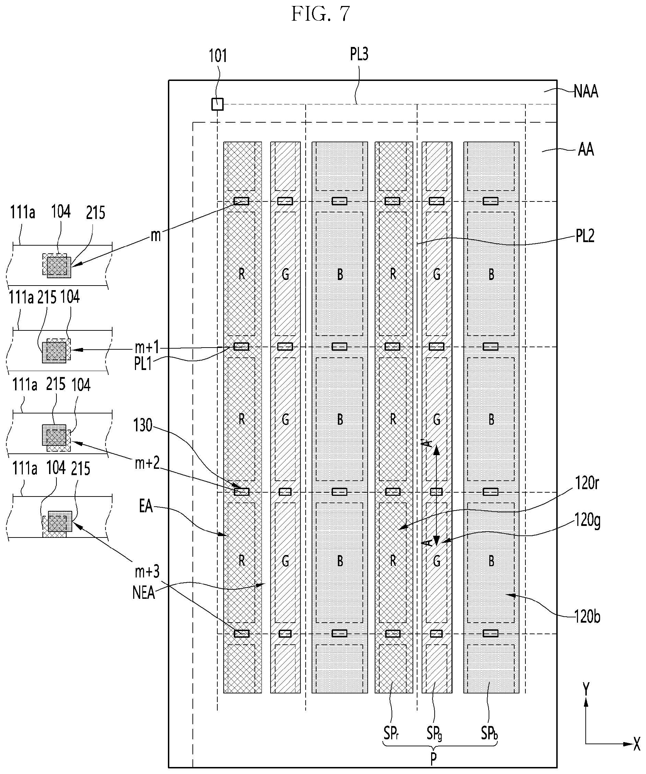

According to at least one of the embodiments, as illustrated in FIGS. 7 to 9, in the plurality of connection structures 130 on the plurality of row lines along the second direction Y, a plurality of undercut structures 138 may be formed to be positioned differently from each other in the first grooves 104 and 131-1 of the plurality of first banks 111-1 and/or the interlayer-insulating layer 103. Accordingly, the cathode electrodes may be formed on a plurality of auxiliary electrodes 132 through the plurality of undercut structures 138 formed at different positions.

As illustrated in FIGS. 7 to 9, four connection structures 130 may be provided through the undercut structures 138 formed at different positions. The undercut structures 138 may be formed on two side portions of the four side portions of the first grooves 104 and 131-1, and the undercut structures 138 may not be formed on the remaining two side portions.

The organic light-emitting material evaporated in a certain direction and at a certain angle from the deposition apparatus may not be deposited in some regions of the auxiliary electrode 132 due to a shadow effect in the undercut structure 138, so that some regions may be exposed. Then, when the green cathode electrode material is deposited, the green cathode electrode material may be continuously connected without a break in a region where the undercut structure 138 is not formed, and may be in contact with the auxiliary electrode 132 through the exposed some regions.

Depending on the direction of progression of the substrate 110 during deposition and the angle and position of an evaporation source, at least one connection structure of the four connection structures 130 may be electrically connected to the green cathode electrode 123g and the auxiliary electrode 132 of the connection structure 130, thereby increasing reliability.

Therefore, electrical connection failure between the cathode electrode and the first power wiring PL1 through the connection structure 130 is prevented, thereby preventing light emission failure or operation failure, thereby increasing reliability.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view schematically illustrating an organic light-emitting display device according to a first embodiment.
FIG. 2 is a cross-sectional view illustrating an organic light-emitting display device according to a first embodiment.
FIG. 3 is a cross-sectional view illustrating an organic light-emitting display device according to a second embodiment.
FIG. 4 is a cross-sectional view illustrating an organic light-emitting display device according to a third embodiment.
FIGS. 5A to 5K illustrate a manufacturing process of an organic light-emitting display device along line A-A' of FIG. 1.
FIGS. 6A to 6K illustrate a manufacturing process of an organic light-emitting display device along line D-D' of FIG. 1.
FIG. 7 illustrates a state in which a groove of a photosensitive pattern is differently positioned relative to a groove of an interlayer-insulating layer along the second direction Y.
FIG. 8 illustrates a positional relationship between a groove of an interlayer-insulating layer and a groove of a photosensitive pattern.
FIG. 9 illustrates a state in which a groove of a photosensitive pattern is disposed on different sides of a groove of an interlayer-insulating layer.
FIG. 10 is a cross-sectional view illustrating an organic light-emitting display device according to a fourth embodiment.
FIG. 11 illustrates a waterproof structure according to a first embodiment.
FIG. 12 illustrates a waterproof structure according to a second embodiment.
FIG. 13 illustrates a waterproof structure according to a third embodiment.
FIG. 14 is a plan view schematically illustrating an organic light-emitting display device according to a second embodiment.
FIG. 15 is a cross-sectional view illustrating an organic light-emitting display device according to a fifth embodiment.

The sizes, shapes, dimensions, etc. of elements illustrated in the drawings can differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

Hereinafter, an organic light-emitting display device having a side-by-side structure manufactured using a photolithography process is disclosed. This structure is referred to as Ph-SbS (side-by-side structure by photolithography). By using a photolithography process, there is no need to use an FMM, so that the process can be simplified and the process cost can be reduced. In addition, the EAR within the subpixel may be increased, so that the lifespan can be improved. In addition, since the organic light-emitting element is deposited on a large-area substrate in an in-line deposition system, productivity, yield, and material utilization efficiency can be improved.

Hereinafter, a red subpixel may be named a first subpixel, a green subpixel may be named a second subpixel, and ta blue subpixel may be named a third subpixel. In addition, a red organic light-emitting element may be named a first organic light-emitting element, a green organic light-emitting element may be named a second organic light-emitting element, and a blue organic light-emitting element may be named a third organic light-emitting element.

Hereinafter, the organic light-emitting display device is a top emission type in which light is emitted in an upper direction of the substrate to display an image, but a bottom emission type in which light is emitted in a lower direction of the substrate to display an image may also be included in the technical idea of the present invention.

FIG. 1 is a plan view schematically illustrating an organic light-emitting display device according to a first embodiment.

As illustrated in FIG. 1, the organic light-emitting display device according to the first embodiment may comprise a plurality of pixels P arranged in a matrix. The plurality of pixels P may be arranged in a display region AA. The remaining region excluding the display region AA may be defined as a non-display region NAA.

The plurality of pixels P may comprise, for example, a plurality of red subpixels SPr, a plurality of green subpixels SPg, a plurality of blue subpixels SPb, etc. The plurality of subpixels SPr, SPg, and SPb may have different colors along a first direction X and may have the same color along a second direction Y crossing the first direction X, but is not limited thereto. That is, the plurality of subpixels SPr, SPg and SPb may have a stripe pattern having the same color and disposed lengthwise along the second direction Y.

As will be explained later, the organic light-emitting layer and the cathode electrode of each of the plurality of organic light-emitting elements 120r, 120g, and 120b may have a stripe pattern having the same color and disposed lengthwise along the second direction Y. For example, a plurality of red subpixels SPr emitting red light may be arranged in a stripe shape along the second direction Y. For example, a plurality of green subpixels SPg emitting green light may be arranged in a stripe shape along the second direction Y. For example, a plurality of blue subpixels SPb emitting blue light may be arranged in a stripe shape along the second direction Y.

The red subpixels SPr, the green subpixels SPg, and the blue subpixels SPb may be alternately arranged in a column-line unit along the first direction X, so that an organic light-emitting display device having a side-by-side structure may be implemented. For example, the red subpixels SPr, the green subpixels SPg, and the blue subpixels SPb may be arranged alternately in the order along the first direction X, but is not limited thereto.

For example, the red organic light-emitting element 120r may be disposed in the red subpixel SPr, the green organic light-emitting element 120g may be disposed in the green subpixel SPg, and the blue organic light-emitting element 120b may be disposed in the blue subpixel SPb.

For example, the luminescence efficiency of the blue organic light-emitting element 120b in the blue subpixel SPb may be lower than the luminescence efficiency of the red organic light-emitting element 120r in the red subpixel SPr or the green organic light-emitting element 120g in the green subpixel SPg. In this instance, since the area of the blue subpixel SPb is designed to be larger than the area of the red subpixel SPr or the area of the green subpixel SPg, the luminescence efficiency among the plurality of subpixels SPr, SPg, and SPb can be uniform, thereby improving the image quality.

The plurality of subpixels SPr, SPg, and SPb may each comprise an emission region EA and a non-emission region NEA. The emission region EA is a region where the organic light-emitting elements 120r, 120g, and 120b are disposed, and the non-emission region NEA may be defined as the remaining region excluding the emission region EA.

The red organic light-emitting element 120r, the green organic light-emitting element 120g, and the blue organic light-emitting element 120b may each comprise an anode electrode, an organic light-emitting layer, a cathode electrode, etc. The organic light-emitting layer may comprise a hole injection layer, a hole transport layer, an organic emission layer, an electron transport layer, an electron injection layer, a charge generation layer, etc. The red organic light-emitting element 120r, the green organic light-emitting element 120g, and the blue organic light-emitting element 120b may each comprise at least two stack structures. Each stack structure may comprise an organic emission layer that emits light.

The organic light-emitting layer and the cathode electrode may be disposed only in each of the plurality of subpixels SPr, SPg, and SPb along the first direction X. That is, the organic light-emitting layer and the cathode electrode may not be disposed continuously along the first direction X but may be separated from each other. Alternatively, as described above, the organic light-emitting layer and the cathode electrode of each of the plurality of organic light-emitting elements 120r, 120g, and 120b may have a stripe pattern having the same color and being disposed lengthwise along the second direction Y. That is, the organic light-emitting layer and the cathode electrode may be disposed across each of the plurality of subpixels SPr, SPg, and SPb along the second direction Y. That is, the organic light-emitting layer and the cathode electrode may be disposed to connect the plurality of subpixels SPr, SPg and SPb along the second direction Y, as well as the regions between the plurality of subpixels SPr, SPg and SPb.

Although not illustrated, the organic light-emitting layer and the cathode electrode may be separated into at least two or more subpixel units or two or more row-line units along the second direction Y.

The anode electrode may be disposed only within the plurality of subpixels SPr, SPg, and SPb along the first direction X and the second direction Y. That is, the anode electrode may not be disposed between the plurality of subpixels SPr, SPg, and SPb along the first direction X and the second direction Y. Accordingly, the emission regions EA of the plurality of subpixels SPr, SPg, and SPb may be distinguished by the anode electrodes individually provided in the plurality of subpixels SPr, SPg, and SPb.

Meanwhile, a plurality of power wirings PL1 to PL3 may be provided to supply power to a plurality of subpixels SPr, SPg, and SPb. A power terminal 101 may be electrically connected to the third power wiring PL3 and may receive a first potential voltage from a power supply unit (not illustrated).

The plurality of power wirings PL1 to PL3 may be disposed in the non-display region NAA and the display region AA. The first and second power wirings PL1 and PL2 may be disposed between the plurality of subpixels SPr, SPg, and SPb in the display region AA and may be electrically connected to the plurality of subpixels SPr, SPg, and SPb. The first and second power wirings PL1 and PL2 may be electrically connected to a plurality of cathode electrodes of the plurality of organic light-emitting elements 120r, 120g, and 120b provided in the plurality of subpixels SPr, SPg, and SPb.

The plurality of first power wirings PL1 and the plurality of second power wirings PL2 may intersect and be connected to each other. The plurality of first power wirings PL1 and the plurality of second power wirings PL2 may have a matrix structure.

The third power wiring PL3 may be disposed in the non-display region NAA and may be electrically connected to, for example, the plurality of second power wirings PL2.

Although not illustrated, another power wiring may be provided to supply a second potential voltage greater than the first potential voltage. Another power wiring may be electrically connected to the driving transistors of each of the subpixels SPr, SPg, and SPb, but is not limited thereto.

The plurality of subpixels SPr, SPg, and SPb may each comprise a driving circuit comprising a driving transistor, etc.

When a specific subpixel is selected by a scan transistor responding to a scan signal, light having luminance corresponding to a current flowing in the driving transistor may be emitted from the specific subpixel by using the first potential voltage of the first and second power wiring PL1 and PL2 and the second potential voltage of another power wiring.

Meanwhile, a plurality of connection structures 130, a plurality of waterproof structures, a plurality of open structures, etc. may be disposed between the plurality of subpixels SPr, SPg, and SPb.

The plurality of connection structures 130 may be disposed between the plurality of subpixels SPr, SPg, and SPb on the second direction Y.

The connection structure 130 may electrically connect the second power wiring PL2 disposed between the plurality of subpixels SPr, SPg, and SPb on the second direction Y to the plurality of cathode electrodes of the plurality of organic light-emitting elements 120r, 120g, and 120b of the plurality of subpixels SPr, SPg, and SPb.

A plurality of open structures may be disposed between a plurality of subpixels SPr, SPg, and SPb along the first direction X and/or the second direction Y.

The open structure may be a structure that separates a layer comprising a low-resistance organic light-emitting material of each of the organic light-emitting elements 120r, 120g, and 120b, such as a hole injection layer, a charge generation layer, etc. to prevent an electrical short between the anode electrode and the cathode electrode and reduce leakage current between the subpixels.

As will be described later, a transverse leakage current or a longitudinal leakage current between the plurality of subpixels SPr, SPg, and SPb may be prevented by the open structure. The transverse leakage current may be a leakage current flowing between adjacent subpixels SPr, SPg, and SPb along the first direction X, and the longitudinal leakage current may be a leakage current flowing between adjacent subpixels SPr, SPg, and SPb along the second direction Y. In addition, electrical short between the anode electrode and the cathode electrode in the corresponding subpixels SPr, SPg, and SPb can be prevented by the open structure. Therefore, by using the open structure, color spot due to leakage current can be improved and luminescence efficiency and luminance can be significantly improved.

A plurality of waterproof structures may be disposed in the non-display region NAA and the display region AA. For example, a plurality of waterproof structures may be disposed between a plurality of subpixels SPr, SPg, and SPb in the first direction X and/or the second direction Y in the non-display region NAA and the display region AA. A plurality of waterproof structures may be disposed in the non-emission region NEA of each of the plurality of subpixels SPr, SPg, and SPb in the first direction X and/or the second direction Y.

Meanwhile, the organic light-emitting layer, etc. is vulnerable to moisture, oxygen, etc., and when the organic light-emitting layer, etc. is damaged by moisture, oxygen, etc., the corresponding subpixels SPr, SPg, and SPb may not operate, resulting in poor luminescence efficiency. If many subpixels SPr, SPg, and SPb do not operate due to moisture, oxygen, etc., display defects such as point emission failure or region emission failure may occur, which may lower product reliability.

However, a plurality of waterproof structures such as the embodiment can prevent moisture, oxygen, etc. from penetrating into the non-display region NAA or the display region AA, thereby preventing operation defects or light-emitting defects of the plurality of subpixels SPr, SPg, and SPb. Accordingly, the organic light-emitting layers of the subpixel SPr, SPg, and SPb may be not affected by moisture, oxygen, etc., so that reliability can be dramatically improved.

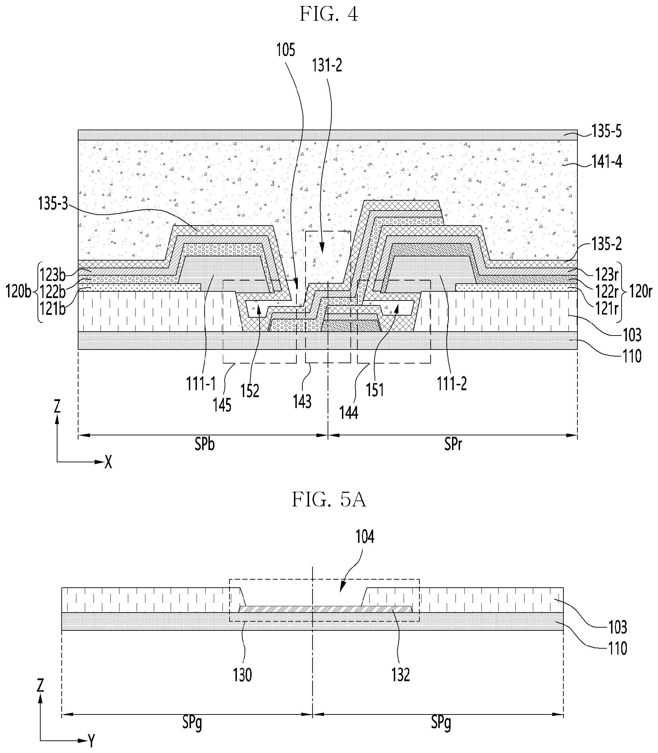

FIG. 2 is a cross-sectional view illustrating an organic light-emitting display device according to a first embodiment. FIG. 3 is a cross-sectional view illustrating an organic light-emitting display device according to a second embodiment. FIG. 4 is a cross-sectional view illustrating an organic light-emitting display device according to a third embodiment. FIGS. 2 to 4 are cross-sectional views cut along lines A-A', B-B', and C-C' in FIG. 1, respectively.

Referring to FIGS. 1 to 4, the organic light-emitting display device according to the embodiment may comprise a plurality of banks 111-1 and 111-2, a plurality of power wirings PL1 to PL3, a plurality of organic light-emitting elements 120r and 120g, a plurality of connection structures 130, etc.

The plurality of banks 111-1 and 111-2, the plurality of power wirings PL1 to PL3, the plurality of organic light-emitting elements 120r and 120g, and the plurality of connection structures 130 may be disposed on a substrate 110.

An interlayer-insulating layer 103 may be disposed on the substrate 110, and the plurality of banks 111-1 and 111-2, the plurality of organic light-emitting elements 120r and 120g, and the plurality of connection structures 130 may be disposed on the interlayer-insulating layer 103.

A plurality of driving circuits may be formed on the substrate 110. The plurality of driving circuits may be provided in the plurality of subpixels SPr, SPg, and SPb, respectively. The plurality of driving circuit may comprise a plurality of transistors, at least one or more capacitor, etc. The plurality of transistor may comprise a scan transistor, a driving transistor, a sensing transistor, etc.

An interlayer-insulating layer 103 may be disposed on the plurality of driving circuits. The interlayer-insulating layer 103 may be a planarization layer whose an upper surface thereof is flat

Meanwhile, a plurality of power wirings PL1 to PL3 may be disposed on the substrate 110. The plurality of power wirings may comprise a plurality of first power wirings PL1, a plurality of second power wirings PL2, a third power wiring PL3, etc.

The third power wiring PL3 may be electrically connected to the power terminal 101. The first power wiring PL1 and the second power wiring PL2 may electrically connect the third power wiring PL3 to a plurality of subpixels SPr, SPg, and SPb on the display region AA.

The third power wiring PL3 may be disposed on a different layer from the first and second power wiring PL1 and PL2, and the first and second power wiring PL1 and PL2 may be disposed on the same layer, but is not limited thereto.

The first and second power wiring PL1 and PL2 may be electrically connected to the third power wiring PL3 by using a contact pad. For example, the second power wiring PL2 may be disposed to extend from the display region AA to the non-display region NAA, and may be electrically connected to the third power wiring PL3 by using a contact pad in the non-display region NAA. The contact pad may be disposed in the non-display region NAA, but is not limited thereto.

For example, the first and second power wiring PL1 and PL2 may be formed together with a source electrode and a drain electrode of the driving transistor. That is, the source electrode and the drain electrode of the driving transistor and the first and second power wiring PL1 and PL2 may be formed on the same layer with the same material using the same process.

For example, the third power wiring PL3 may be formed together with the cathode electrode. That is, the cathode electrode and the third power wiring PL3 may be formed on the same layer with the same material using the same process.

Meanwhile, the plurality of first power wiring PL1 may be disposed between the plurality of subpixels SPr, SPg, and SPb along the second direction Y, and the plurality of second power wiring PL2 may be disposed between the plurality of subpixels SPr, SPg, and SPb along the first direction X. The plurality of first power wiring PL1 may be disposed lengthwise along the first direction X between the plurality of subpixels SPr, SPg, and SPb along the second direction Y. A plurality of second power wirings PL2 may be disposed lengthwise along the second direction Y between a plurality of subpixels SPr, SPg, and SPb on the first direction X.

The plurality of banks may comprise a plurality of first banks 111-1 and a plurality of second banks 111-2. The first banks 111-1 and the second banks 111-2 may intersect and be connected to each other. The plurality of first banks 111-1 and the plurality of second banks 111-2 may have a matrix structure.

A plurality of first banks 111-1 may be disposed to correspond to a plurality of first power wiring PL1, and a plurality of second banks 111-2 may be disposed to correspond to a plurality of second power wiring PL2. That is, a plurality of first banks 111-1 may be disposed on a plurality of first power wiring PL1, and a plurality of second banks 111-2 may be disposed on a plurality of second power wiring PL2.

A plurality of first banks 111-1 may be disposed between a plurality of subpixels SPr, SPg and SPb in the second direction Y, and a plurality of second banks 111-2 may be disposed between a plurality of subpixels SPr, SPg and SPb in the first direction X. A plurality of first banks 111-1 may be disposed lengthwise along the first direction X between a plurality of subpixels SPr, SPg and SPb in the second direction Y. A plurality of second banks 111-2 may be disposed lengthwise along the second direction Y between a plurality of subpixels SPr, SPg and SPb in the first direction X.

The plurality of subpixels SPr, SPg and SPb may each comprise an emission region EA and a non-emission region NEA.

As an example, the emission region EA may be separated by the first bank 111-1 and the second bank 111-2. The emission region EA may be surrounded by the first bank 111-1 and the second bank 111-2.

As another example, the emission region EA may be separated by anode electrodes 121r, 121g and 121b individually provided in each of the subpixels SPr, SPg, and SPb.

As another example, the emission region EA may be defined by organic light-emitting layers 122r, 122g and 122b exposed by the first bank 111-1 and the second bank 111-2.

Meanwhile, the regions corresponding to the first and second banks 111-1 and 111-2, respectively, may be defined as non-emission regions NEA. In this instance, the first and second banks 111-1 and 111-2 may be shared by adjacent subpixels. That is, some of the first and second banks 111-1 and 111-2 may be included in one subpixel, and other some of the first and second banks 111-1 and 111-2 may be included in another subpixel adjacent to one subpixel.

The plurality of organic light-emitting elements 120r, 120g and 120b may be disposed in the plurality of subpixels SPr, SPg, and SPb. The plurality of organic light-emitting elements 120r, 120g and 120b may comprise a plurality of anode electrodes 121r, 121g and 121b, a plurality of organic light-emitting layers 122r, 122g and 122b, and a plurality of cathode electrodes 123r, 123g and 123b.

The anode electrodes 121r, 121g and 121b may be disposed only in the subpixels SPr, SPg, and SPb, respectively, along the first direction X and the second direction Y. The red anode electrode 121r may be disposed only on the plurality of red subpixels SPr along the second direction Y, the green anode electrode 121g may be disposed only on the plurality of green subpixels SPg along the second direction Y, and the blue anode electrode 121b may be disposed only on the plurality of blue subpixels SPb along the second direction Y.

The organic light-emitting layers 122r, 122g and 122b may be separated from each other along the first direction X, but may be disposed along the second direction Y. The red organic light-emitting layer 122r may be disposed on the plurality of red subpixels SPr as well as the plurality of first banks 111-1 along the second direction Y. The green organic light-emitting layer 122g may be disposed on the plurality of green subpixels SPg as well as the plurality of first banks 111-1 along the second direction Y. The blue organic light-emitting layer 122b may be disposed in the plurality of subpixels SPr, SPg, and SPb as well as in the plurality of first banks 111-1 along the second direction Y. The red organic light-emitting layer 122r, the green organic light-emitting layer 122g, and the blue organic light-emitting layer 122b may be referred to as the first organic light-emitting layer, the second organic light-emitting layer, and the third organic light-emitting layer, respectively.

The cathode electrodes 123r, 123g and 123b may be separated from each other along the first direction X but may be disposed along the second direction Y. The red cathode electrode 123r may be disposed in the plurality of red subpixels SPr as well as in the plurality of first banks 111-1 along the second direction Y. The green cathode electrode 123g may be disposed in the plurality of green subpixels SPg as well as in the plurality of first banks 111-1 along the second direction Y. The blue cathode electrode 123b may be disposed in the plurality of blue subpixels SPb as well as in the plurality of first banks 111-1 along the second direction Y. The red cathode electrode 123r, the green cathode electrode 123g, and the blue cathode electrode 123b may be referred to as the first cathode electrode, the second cathode electrode, and the third cathode electrode, respectively.

The plurality of connection structures 130 may be disposed in the plurality of first banks 111-1. Although it is illustrated that the connection structure 130 is disposed in all of the plurality of first banks 111-1 in the drawing, it may not be disposed in all of the plurality of first banks 111-1. That is, the connection structure 130 may be disposed in some of the plurality of first banks 111-1.

The plurality of first banks 111-1 may have a plurality of first grooves 131-1. The first groove 131-1 may be locally formed only in a part of the first bank 111-1 between the plurality of subpixels SPr, SPg, and SPb on the second direction Y. That is, the first groove 131-1 may have a dot shape. The first groove 131-1 may have a circular or rectangular shape when viewed from above, but are not limited thereto. The first groove 131-1 may be formed by penetrating from an upper surface to a lower surface of the first bank 111-1, but are not limited thereto.

As illustrated in FIG. 2, the connection structure 130 may be disposed in the first groove 131-1 of the first bank 111-1. The connection structure 130 may electrically connect the green cathode electrode 123g in the first groove 131-1 of the first bank 111-1 to the first power wiring PL1.

The green organic light-emitting layer 122g and the green cathode electrode 123g may be disposed across the first bank 111-1 along the second direction Y. In this instance, the green organic light-emitting layer 122g and the green cathode electrode 123g may be separated from each other in the first groove 131-1 of the first bank 111-1. That is, the green organic light-emitting layer 122g on the upper side of the first bank 111-1 and the green organic light-emitting layer 122g in the first groove 131-1 may be separated from each other. F. In this instance, the green cathode electrode 123g may be electrically connected to the connection structure 130 through the separated green organic light-emitting layer 122g in the first groove 131-1.

The red cathode electrode 123r and the blue cathode electrode 123b may be electrically connected to the connection structure 130 in the first groove 131-1, respectively.

An undercut structure 138 may be formed on a lower side of the first bank 111-1 that contacts the first groove 131-1. For example, the undercut structure 138 may be formed such that a side portion of the interlayer-insulating layer 103 in contact with the first groove 131-1 may be recessed from an inner side portion of the first bank 111-1 toward a direction of an outer side.

The connection structure 130 may comprise an auxiliary electrode 132 extended from the first power wiring PL1. Among the first power wirings PL1 disposed lengthwise along the first direction X, the first power wiring PL1 corresponding to the first groove 131-1 of the first bank 111-1 may be formed as an auxiliary electrode 132. Accordingly, the auxiliary electrode 132 may be a part of the first power wiring PL1. A width of the auxiliary electrode 132 may be greater than a width of the first power wiring PL1, but is not limited thereto.

Although FIG. 2 illustrates a plurality of connection structures 130 disposed between a plurality of green subpixels SPg in the second direction Y, a plurality of connection structures 130 disposed between a plurality of red subpixels SPr in the second direction Y and a plurality of connection structures 130 disposed between a plurality of blue subpixels SPb in the second direction Y may also be identical to a plurality of connection structures 130 disposed between a plurality of green subpixels SPg.

Since the green organic light-emitting layer 122g is cut off by the undercut structure 138, a part of the auxiliary electrode 132 may be exposed. Accordingly, the green cathode electrode 123g may be in contact with a part of the exposed auxiliary electrode 132 in the undercut structure 138. In other words, the green cathode electrode 123g may be electrically connected to the first power wiring PL1 through the connection structure 130.

Since the undercut structure 138 cuts off the green organic light-emitting layer 122g and contacts the green cathode electrode 123g with the auxiliary electrode 132, the undercut structure 138 may also be included in the connection structure 130, but is not limited thereto.

The interlayer-insulating layer 103 may have a first groove 104 corresponding to the first groove 131-1 of the first bank 111-1. The first groove 104 of the interlayer-insulating layer 103 may be formed corresponding to the first groove 131-1 of the first bank 111-1 between a plurality of green subpixels SPg on the second direction Y.

The undercut structure 138 may be in contact with the first groove 131-1 of the first bank 111-1 and the first groove 104 of the interlayer-insulating layer 103. In this instance, the auxiliary electrode 132 of the connection structure 130 may be exposed in the undercut structure 138, and the green cathode electrode 123g may be in contact with a part of the exposed auxiliary electrode 132.

Meanwhile, as illustrated in FIG. 4, a plurality of second banks 111-2 may be disposed between a plurality of subpixels SPr, SPg, and SPb in the first direction X. The plurality of second banks 111-2 may be disposed lengthwise along the second direction Y between the plurality of subpixels SPr, SPg, and SPb in the first direction X. A plurality of second grooves 131-2 may be formed in the plurality of second banks 111-2. The plurality of second grooves 131-2 may be disposed lengthwise along the second direction Y between the plurality of subpixels SPr, SPg, and SPb in the first direction X, but is not limited thereto. The second grooves 131-2 may be formed to penetrate from an upper surface to a lower surface of the second bank 111-2, but is not limited thereto.

The interlayer-insulating layer 103 may have a second groove 105 corresponding to the second groove 131-2 of the second bank 111-2. The second groove 105 of the interlayer-insulating layer 103 may be formed corresponding to the second groove 131-2 of the second bank 111-2 between the red subpixel SPr and the green subpixel SPg.

Meanwhile, referring to FIGS. 1 to 4, the organic light-emitting display device according to the embodiment may comprise a plurality of inorganic insulating layers 135-1, 135-2, 135-3, and 135-4, an organic insulating layer 141-4, a plurality of waterproof structures 143 to 145, etc.

The plurality of inorganic insulating layers may comprise a first inorganic insulating layer 135-1, a second inorganic insulating layer 135-2, a third inorganic insulating layer 135-3, and a fourth inorganic insulating layer 135-4. The first inorganic insulating layer 135-1, the second inorganic insulating layer 135-2, the third inorganic insulating layer 135-3, and the fourth inorganic insulating layer 135-4 may each comprise at least one or more inorganic insulating film.

The first inorganic insulating layer 135-1 may be disposed on the green cathode electrode 123g of the green organic light-emitting element 120g in the green subpixel SPg, and the second inorganic insulating layer 135-2 may be disposed on the red cathode electrode 123r of the red organic light-emitting element 120r in the red subpixel SPr. Although not illustrated, the third inorganic insulating layer 135-3 may be disposed on the blue cathode electrode 123b of the blue organic light-emitting element 120b in the blue subpixel SPb.

The first inorganic insulating layer 135-1, the second inorganic insulating layer 135-2, and the third inorganic insulating layer 135-3 may be configured as a double layer comprising a silicon oxide layer and a silicon nitride layer. The silicon nitride layer may be disposed on the silicon oxide layer. For example, the silicon oxide layer may be formed by using an atomic layer deposition (ALD) process, and the silicon nitride layer may be formed by using a chemical vapor deposition (CVD) process.

When each of the first inorganic insulating layer 135-1, the second inorganic insulating layer 135-2, and the third inorganic insulating layer 135-3 is formed as a double layer, each of the first inorganic insulating layer 135-1, the second inorganic insulating layer 135-2, and the third inorganic insulating layer 135-3 may be formed without a break on the lower side of the second bank 111-2, the side portion of the interlayer-insulating layer 103, and the upper side of the second power wiring PL2 in the first undercut structure 151 and the second undercut structure 152.

The first waterproof structure 143 may be formed by overlapping two or more inorganic insulating layers among the first inorganic insulating layer 135-1, the second inorganic insulating layer 135-2, and the third inorganic insulating layer 135-3 in the second groove 131-2 of the second bank 111-2. The waterproof performance of the first waterproof structure 143 can be enhanced by not only forming the first inorganic insulating layer 135-1, the second inorganic insulating layer 135-2, and the third inorganic insulating layer 135-3 as a double layer, but also overlapping two or more inorganic insulating layers among the first inorganic insulating layer 135-1, the second inorganic insulating layer 135-2, and the third inorganic insulating layer 135-3.

The first inorganic insulating layer 135-1, the second inorganic insulating layer 135-2, and the third inorganic insulating layer 135-3 may be formed in a curved shape in the first undercut structure 151 and the second undercut structure 152.

The second waterproof structure 144 may be formed by a curved shape of the first inorganic insulating layer 135-1 formed in the first undercut structure 151. The third waterproof structure 145 may be formed by a curved shape of the second inorganic insulating layer 135-2 formed on the second undercut structure 152. Since the penetration path of moisture, oxygen, etc. is further increased by the curved shape of the first inorganic insulating layer 135-1 or the curved shape of the second inorganic insulating layer 135-2, the waterproof performance of each of the second waterproof structure 144 and the third waterproof structure 145 can be enhanced. Accordingly, the penetration of moisture, oxygen, etc. can be prevented by the second waterproof structure 144 and the third waterproof structure 145, so that the organic light-emitting layers 122r, 122g and 122b and the cathode electrodes 123r, 123g and 123b can be protected from moisture, oxygen, etc. Therefore, operation defects or light-emitting defects of the red subpixel SPr and the green subpixel SPg can be prevented, so that the reliability can be improved.

Although not illustrated, the waterproof structure formed by the third inorganic insulating layer 135-3 can prevent operation defects or light-emitting defects of the blue subpixel SPb.

The fourth inorganic insulating layer 135-4 may be disposed on the entire region of the substrate 110. The fourth inorganic insulating layer 135-4 may comprise at least one or more inorganic insulating film.

Accordingly, penetration of moisture, oxygen, etc. can be completely blocked by disposing the plurality of inorganic insulating layers 135-1, 135-2, and 135-3 on each of the plurality of subpixels SPr, SPg, and SPb or the entire region of the substrate 110.

Meanwhile, as illustrated in FIG. 4, a plurality of waterproof structures 143 to 145 may be disposed in the second groove 131-2 of the second bank 111-2 between the red subpixel SPr and the green subpixel SPg.

The penetration of moisture, oxygen, etc. can be completely blocked by disposing a plurality of waterproof structures, that is, the first waterproof structure 143, the second waterproof structure, and the third waterproof structure 145, in the second groove 131-2 of the second bank 111-2.

The first waterproof structure 143 may be configured such that two or more inorganic insulating layers among the plurality of inorganic insulating layers 135-1, 135-2 and 135-3 are overlapped on the second bank 111-2.

As illustrated in FIG. 4, a first inorganic insulating layer 135-1, a second inorganic insulating layer 135-2, and a third inorganic insulating layer 135-3 may be overlapped on a second groove 131-2 of a second bank 111-2 disposed between a red subpixel SPr and a green subpixel SPg, so that a first waterproof structure 143 may be formed. For example, the second inorganic insulating layer 135-2 may be disposed on the first inorganic insulating layer 135-1, and the third inorganic insulating layer 135-3 may be disposed on the second inorganic insulating layer 135-2. The third inorganic insulating layer 135-3, which is the uppermost layer, may be an island insulating pattern. The island insulating pattern may be a part of the third inorganic insulating layer 135-3 disposed on a blue cathode electrode 123b of the blue subpixel SPb, and may be spaced apart from the third inorganic insulating layer 135-3. Since the first waterproof structure 143 is included in the island insulation pattern, the waterproof performance can be further improved.

Although not illustrated, a plurality of waterproof structures 143 to 145 may be disposed in the second groove 131-2 of the second bank 111-2 disposed between the green subpixel SPg and the red subpixel SPr. In addition, a plurality of waterproof structures 143 to 145 may be disposed in the second groove 131-2 of the second bank 111-2 disposed between the green subpixel SPg and the blue subpixel SPb.

Meanwhile, as illustrated in FIG. 4, the second waterproof structure 144 and the third waterproof structure 145 may be configured by forming one of the plurality of inorganic insulating layers 135-1 and 135-2 in a curved shape by the first undercut structure 151 and the second undercut structure 152. The first undercut structure 151 and the second undercut structure 152 may be formed on the lower side of the second bank 111-2 that contacts the second groove 131-2 of the second bank 111-2. The first undercut structure 151 and the second undercut structure 152 may be formed by removing the interlayer-insulating layer 103 positioned on the lower side of the second bank 111-2 that contacts the second groove 131-2 of the second bank 111-2. That is, the first undercut structure 151 and the second undercut structure 152 may be formed that the side portion of the interlayer-insulating layer 103 may be recessed from the inner side portion of the second bank 111-2 that contacts the second groove 131-2 of the second bank 111-2 toward a direction of an outer side. The second waterproof structure 144 and the third waterproof structure 145 may be disposed on the second power wiring PL2 positioned in the second groove 131-2 of the second bank 111-2.

Meanwhile, a plurality of second power wiring PL2 may be disposed under the plurality of second banks 111-2. The plurality of second power wiring PL2 may be exposed by the plurality of second grooves 131-2 of the plurality of second banks 111-2. In this instance, a first waterproof structure 143 in which at least two or more inorganic insulating layers among the plurality of inorganic insulating layers 135-1 and 135-2 are overlapped may be disposed on the plurality of second power wiring PL2. The first waterproof structure 143 composed of at least two or more inorganic insulating layers may be disposed on the second power wiring PL2 positioned in the second groove 131-2 of the second bank 111-2. At this time, the second power wiring PL2 may be omitted. In the case where the second power wiring PL2 is omitted, at least one of the plurality of first power wiring PL1 may be extended to the non-display region NAA and electrically connected to the power terminal 101.

According to an embodiment, since the connection structure 130 is disposed between the plurality of subpixels SPr, SPg, and SPb having the same color along the second direction Y, power supply is smooth and supply failure such as voltage drop can be prevented, so that image quality can be improved and reliability can be increased.

According to an embodiment, since at least two or more waterproof structures are disposed in the first bank 111-1, moisture, oxygen, etc. penetrating along the second direction Y do not penetrate into the plurality of subpixels SPr, SPg, and SPb, so that operation defects or light-emitting defects of the subpixel can be prevented, thereby improving reliability.

Meanwhile, referring to FIGS. 1 to 3, the organic light-emitting display device according to the embodiment may comprise open structures 134-1 and 134-2. The open structures 134-1 and 134-2 may have undercut structures 115 and 116 formed in an edge region of the first bank 111-1. For example, the open structures 134-1 and 134-2 may be disposed in the edge region of a lower side of each of the plurality of banks 111-1 and 111-2, but is not limited thereto.

The open structures 134-1 and 134-2 may comprise at least one or more blocking layer 113 for forming undercut structures 115 and 116 recessed inwardly from the side portion of the first bank 111-1. The first undercut structure 151 and the second undercut structure 152 may be formed in the edge region of the first bank 111-1 by the blocking layer 113. The blocking layer 113 may comprise a silicon-based inorganic material, a metal, etc. As the metal, aluminum (Al), molybdenum (Mo), a molybdenum alloy, etc. may be used, but is not limited thereto.

Although not illustrated in FIG. 4, the open structures 134-1 and 134-2 may be disposed in an edge region of the second bank 111-2, but may be omitted.

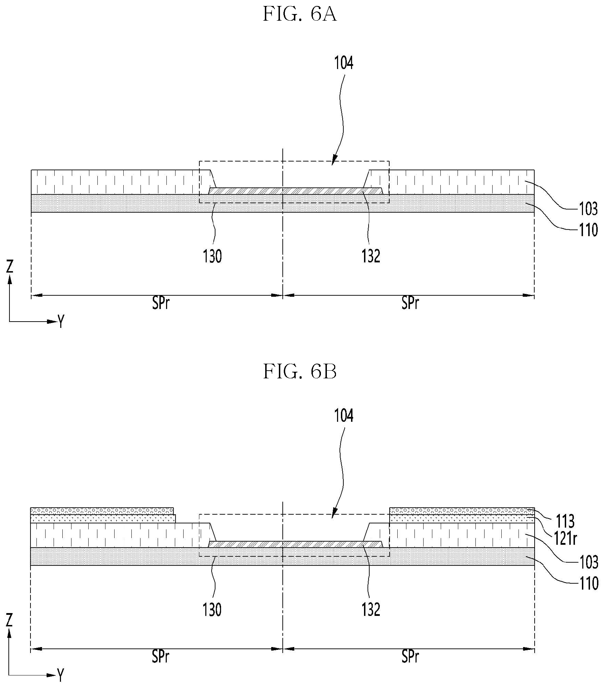

Hereinafter, with reference to FIGS. 5A to 5K and FIGS. 6A to 6K, a process for sequentially manufacturing a green organic light-emitting element 120g and a red organic light-emitting element 120r will be described. Although not illustrated, a blue organic light-emitting element 120b may be manufactured after the red organic light-emitting element 120r is manufactured.

FIGS. 5A to 5K illustrate a manufacturing process of an organic light-emitting display device along line A-A' of FIG. 1. FIGS. 6A to 6K illustrate a manufacturing process of an organic light-emitting display device along line D-D' of FIG. 1. A green organic light-emitting element 120g may be manufactured through the manufacturing process illustrated in FIGS. 5A to 5K, and a red organic light-emitting element 120r may be manufactured through the manufacturing process illustrated in FIGS. 6A to 6K. The manufacturing process of the blue organic light-emitting element 120b can be easily understood through the manufacturing process of the red organic light-emitting element 120r illustrated in FIGS. 6A to 6K.

Although FIGS. 5A to 5K and FIGS. 6A to 6K illustrate that the green organic light-emitting element 120g, the red organic light-emitting element 120r, and the blue organic light-emitting element 120b may be manufactured in that order, the order may also be changed.

As illustrated in FIGS. 1, 5A, and 6A, a driving circuit, a first power wiring PL1, a second power wiring PL2, an auxiliary electrode 132, and an interlayer-insulating layer 103 may be formed on a substrate 110.

The substrate 110 may comprise a material having excellent insulating performance. For example, the substrate 110 may comprise a plastic material, a resin material, glass, etc. The substrate 110 may comprise a rigid material or a flexible material.

The driving circuit may comprise a plurality of transistors comprising a driving transistor, at least one or more capacitor, etc. The driving circuit may be formed on the substrate 110 using a semiconductor process. Each of the plurality of transistors may comprise a gate electrode, a source electrode, and a drain electrode.

The first power wiring PL1, the second power wiring PL2, and the auxiliary electrode 132 may be formed of the same material as the source electrode and the drain electrode.

The auxiliary electrode 132 may be formed by extending from the first power wiring PL1 and may constitute a part of the first power wiring PL1. The auxiliary electrode 132 may be formed between a plurality of green subpixels SPg in the second direction Y. Although not illustrated, the auxiliary electrode 132 may be formed between a plurality of red subpixels SPr in the second direction Y and/or between a plurality of blue subpixels SPb in the second direction Y.

An interlayer-insulating layer 103 may be formed on the first power wiring PL1, the second power wiring PL2, and the auxiliary electrode 132. Thereafter, the interlayer-insulating layer 103 may be removed so that the auxiliary electrode 132 may be exposed, and a first groove 104 may be formed in the interlayer-insulating layer 103.

The interlayer-insulating layer 103 may be a single organic insulating film or may comprise a plurality of insulating films comprising an organic insulating film and an inorganic insulating film.

The interlayer-insulating layer 103 between a plurality of subpixels SPr, SPg, and SPb on the second direction Y may be removed through an etching process, so that the first groove 104 may be formed. An upper surface of the auxiliary electrode 132 may be exposed by the first groove 104. A connection structure 130 may be formed by the auxiliary electrode 132.

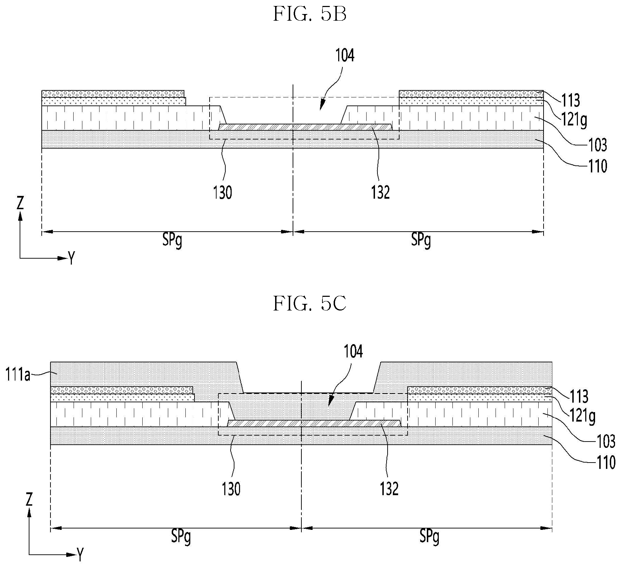

As illustrated in FIGS. 5B and 6B, a green anode electrode 121g and a red anode electrode 121r may be formed on the interlayer-insulating layer 103. The red anode electrode 121r may be formed on the red subpixel SPr, and the green anode electrode 121g may be formed on the green subpixel SPg. Although not illustrated, a blue anode electrode may be formed on the blue subpixel SPb.

A blocking layer 113 may be formed on the green anode electrode 121g and the red anode electrode 121r.

For example, a conductive film and a blocking film may be formed on a substrate and patterned, so that the green anode electrode 121g, the red anode electrode 121r, and the blocking layer 113 may be formed. When the conductive film and the blocking film are etched using the same photosensitive pattern, a side surface of the patterned green anode electrode 121g and a side surface of the patterned blocking layer 113 may be positioned on the same vertical line or diagonal line, and a side surface of the patterned red anode electrode 121r and a side surface of the patterned blocking layer 113 may be positioned on the same vertical line or diagonal line.

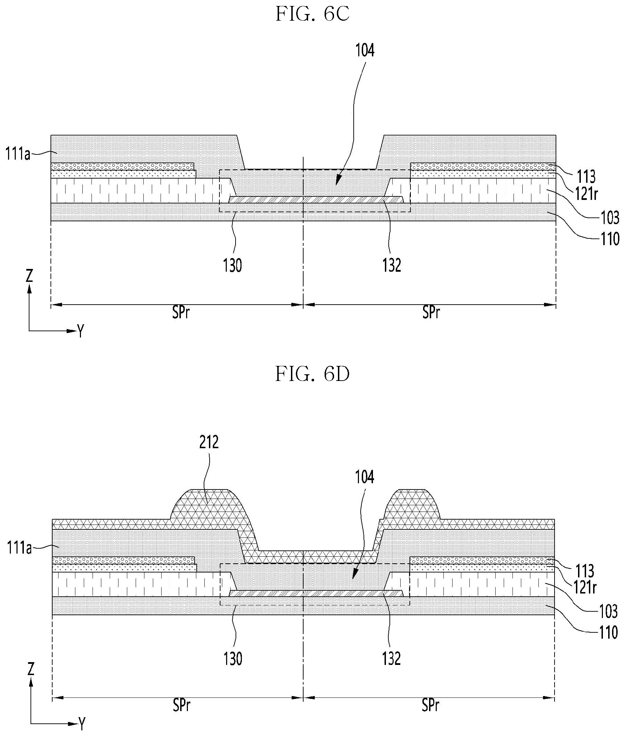

As illustrated in FIGS. 5C and 6C, an inorganic film 111a may be formed on the interlayer-insulating layer 103.

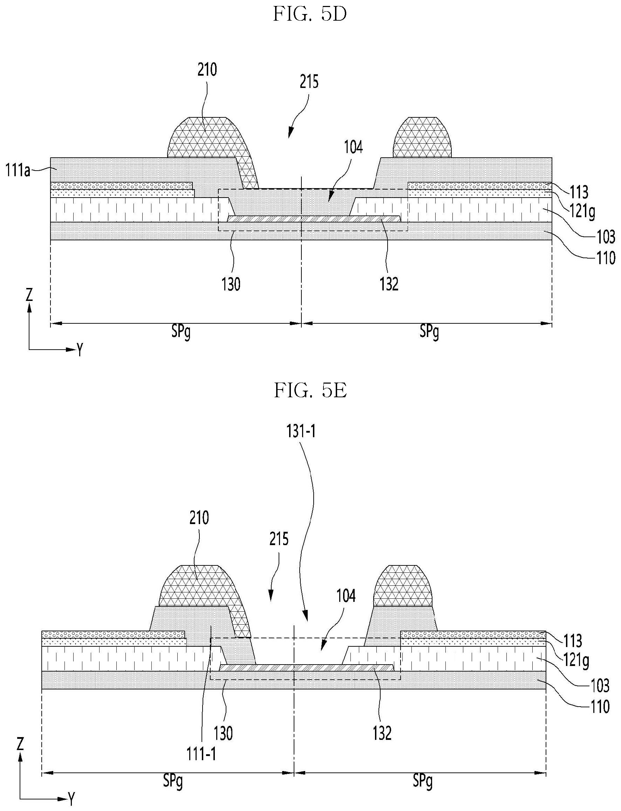

As illustrated in FIGS. 5D and 6D, a first photosensitive pattern 210 and a second photosensitive pattern 212 may be formed on the inorganic film 111a.

The first photosensitive pattern 210 may have a groove 215 on the auxiliary electrode 132 between a plurality of green subpixels SPg in the second direction Y. An upper surface of the inorganic film 111a may be exposed by the groove 215.

The second photosensitive pattern 212 may be formed on the auxiliary electrode 132 between the plurality of red subpixels SPr as well as the plurality of red subpixels SPr in the second direction Y. At this time, the thickness of the second photosensitive pattern 212 on the auxiliary electrode 132 may be formed as a half mask thicker than the thickness on the red subpixels SPr.

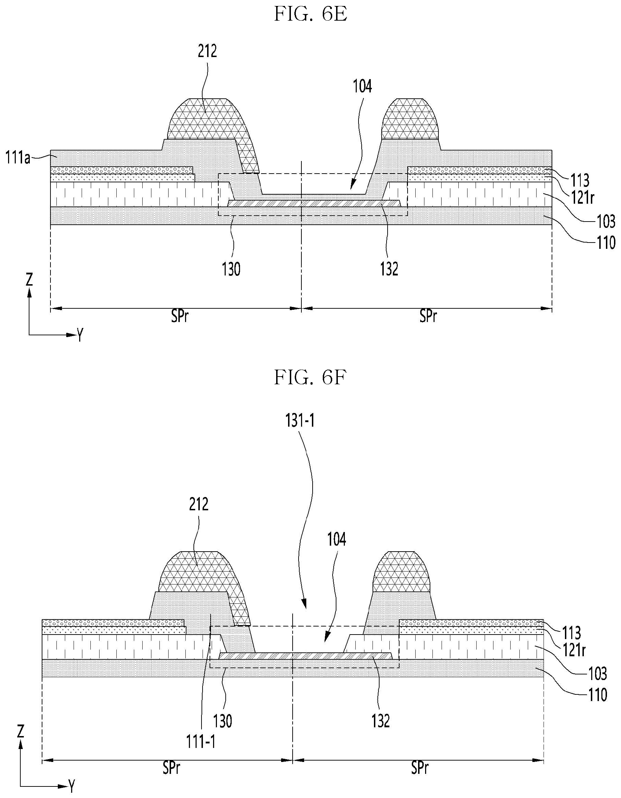

As illustrated in FIGS. 5E and 6E, a dry etching process may be performed using the first photosensitive pattern 210 and the second photosensitive pattern 212, so that the inorganic film 111a may be removed.

The inorganic film 111a exposed by the first photosensitive pattern 210 may be removed to expose the blocking layer 113 and the auxiliary electrode 132. That is, the inorganic film 111a on the green anode electrode 121g may be removed, and the inorganic film 111a on the auxiliary electrode 132 between the green subpixels SPg may be removed. By removing the inorganic film 111a on the auxiliary electrode 132 between the green subpixels SPg, the first bank 111-1 having the first groove 131-1 may be formed. The first groove 131-1 may be locally formed only on the first bank 111-1 between adjacent green subpixels SPg along the second direction Y.

In contrast, since the inorganic film 111a is protected by the second photosensitive pattern 212, the inorganic film 111a on the plurality of red subpixels SPr and the auxiliary electrode 132 may not be removed.

Meanwhile, by performing a dry etching process, the second photosensitive pattern 212 on the remaining region except for the periphery of the auxiliary electrode 132 between the plurality of red subpixels SPr may be removed. By removing the second photosensitive pattern 212 on the remaining region, the upper surface of the inorganic film 111a may be exposed. The exposed upper surface of the inorganic film 111a may be removed by the dry etching process, thereby reducing the thickness of the inorganic film 111a, but is not limited thereto.

Next, a wet etching process may be performed using the first photosensitive pattern 210 and the second photosensitive pattern 212.

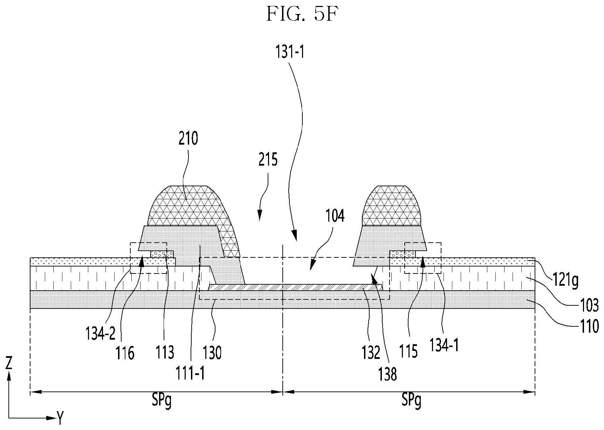

As illustrated in FIG. 5F, the blocking layer 113 in the green subpixel SPg may be removed through a wet etching process. As the wet etching process is continuously performed, the blocking layer 113 positioned under the first bank 111-1 may be removed, so that undercut structures 115 and 116 may be formed. That is, a side portion of the blocking layer 113 may be recessed inwardly from the outer side portion of the first bank 111-1, so that open structures 134-1 and 134-2 having undercut structures 115 and 116 may be formed.

Then, another etching process may be additionally performed so that the interlayer-insulating layer 103 exposed in the first groove 131-1 of the first bank 111-1 may be recessed from the lower side of the first bank 111-1 toward a direction of and outer side, so that an undercut structure 138 may be formed. The connection structure 130 may also comprise the undercut structure 138 together with the auxiliary electrode 132, but is not limited thereto.

In contrast, as illustrated in FIGS. 6E and 6F, the inorganic film 111a may be removed through a wet etching process, so that the blocking layer 113 in the red subpixel SPr may be exposed, and the first bank 111-1 having the first groove 131-1 may be formed. The auxiliary electrode 132 may be exposed by the first groove 131-1.

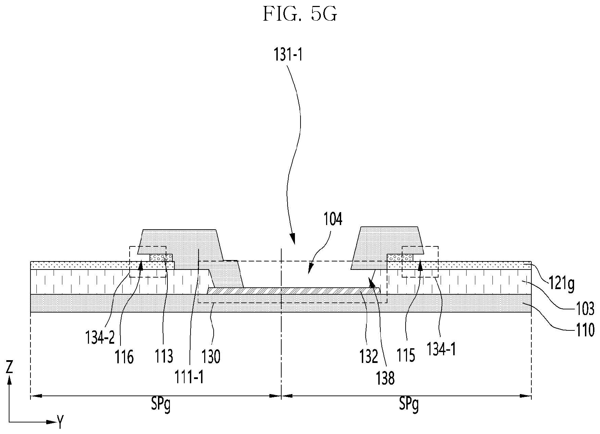

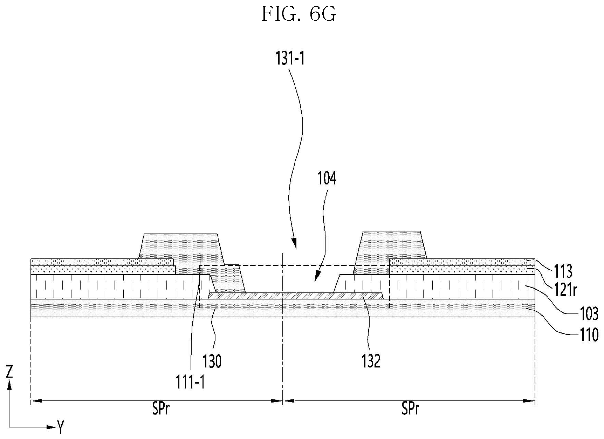

As illustrated in FIGS. 5G and 6G, after the first photosensitive pattern 210 and the second photosensitive pattern 212 are removed, a cleaning process may be performed.

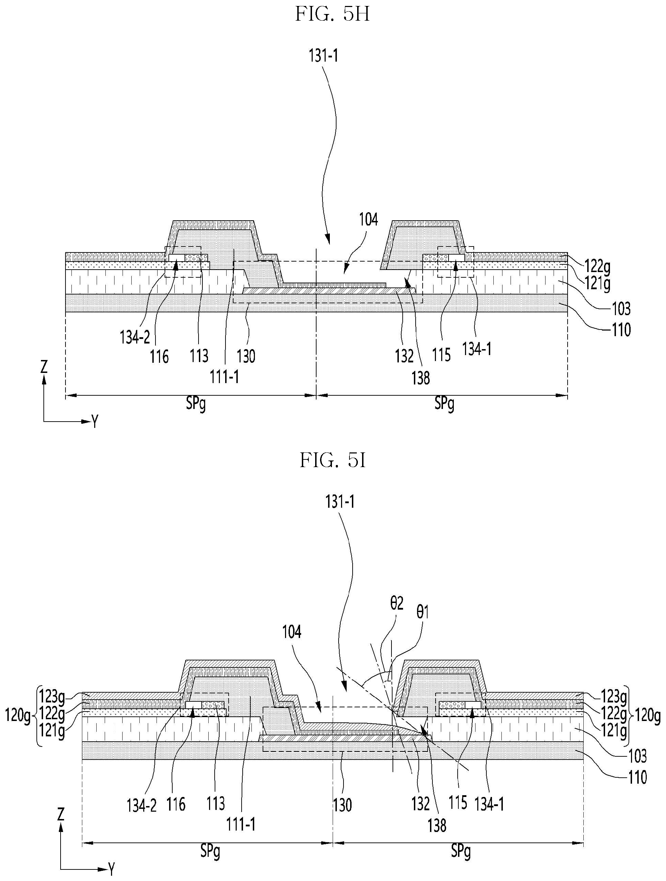

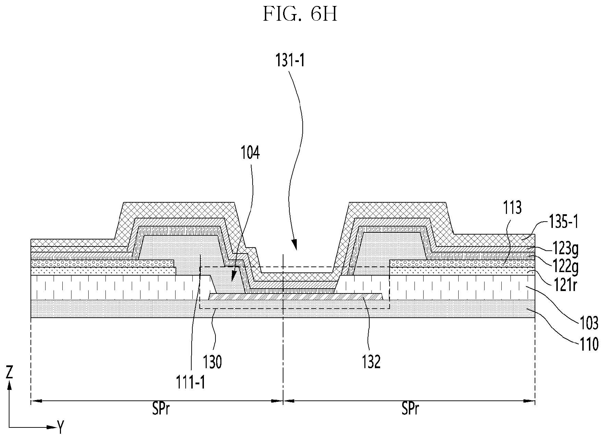

As illustrated in FIGS. 5H to 5J and FIG. 6H, the green organic light-emitting layer 122g, the green cathode electrode 123g, and the first inorganic insulating layer 135-1 may be formed on the entire region of the substrate 110 or on the display region AA of the substrate 110.

First, as illustrated in FIG. 5H, the green organic light-emitting layer 122g may be deposited on the entire region of the substrate 110 or on the display region AA of the substrate 110. The green organic light-emitting layer 122g may be deposited on the red subpixel SPr, the green subpixel SPg, the blue subpixel SPb, and the first and second banks 111-1 and 111-2.

The green organic light-emitting layer 122g may have at least two or more stack structures. The green organic light-emitting layer 122g may comprise a hole injection layer, a hole transport layer, an organic emission layer, an electron transport layer, an electron injection layer, a charge generation layer, etc.

The green organic light-emitting layer 122g may be separated by the undercut structure 138. That is, the green organic light-emitting layer 122g formed in the first groove 131-1 of the first bank 111-1 and the green organic light-emitting layer 122g formed on the upper side of the first bank 111-1 may be separated from each other by the undercut structure 138.

Some layers of the green organic light-emitting layer 122g, such as the hole injection layer and/or charge generation layer, may be cut off by the undercut structures 115 and 116 of the open structures 134-1 and 134-2, so that leakage current flowing to a hole injection layer, a charge generation layer, etc. may be blocked, thereby preventing poor image quality.

As illustrated in FIG. 5I, the green cathode electrode 123g may be deposited on the green organic light-emitting layer 122g. The green organic light-emitting layer 122g and the green cathode electrode 123g may be deposited using different deposition angles θ1 and θ2. The deposition angles may be defined with respect to a vertical line.

The deposition angle θ2 for depositing the green cathode electrode 123g may be greater than the deposition angle θ1 for depositing the green organic light-emitting layer 122g. In this instance, the green organic light-emitting layer 122g may be deposited at the entrance of the undercut structure 138. In contrast, the green cathode electrode 123g may be deposited even inside the undercut structure 138, so that it may be in contact with a part of the upper surface of the auxiliary electrode 132 in the undercut structure 138.

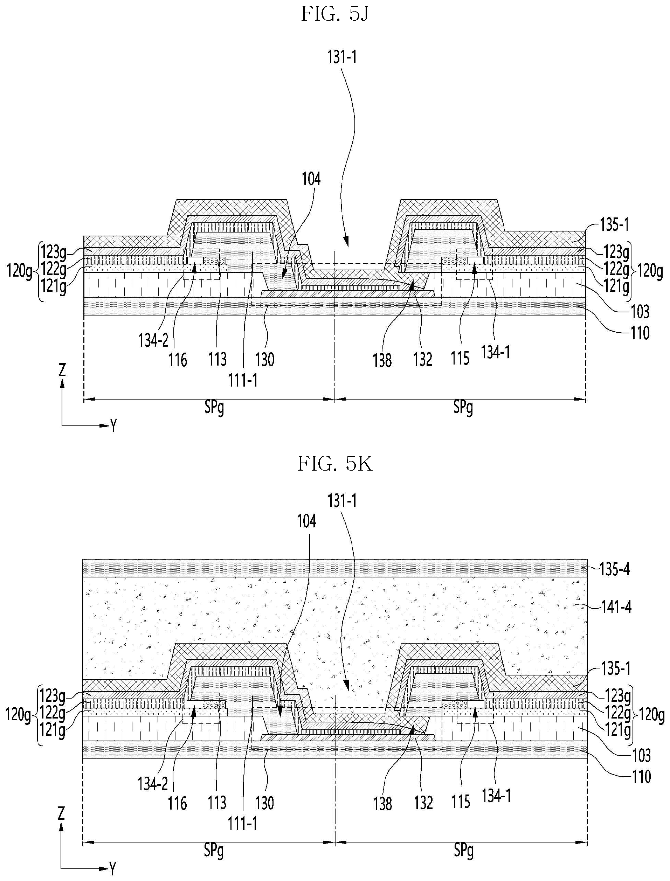

As illustrated in FIG. 5J, the first inorganic insulating layer 135-1 may be formed on the green cathode electrode 123g.

As illustrated in FIG. 6H, the green organic emitting layer 122g, the green cathode electrode 123g, and the first inorganic insulating layer 135-1 may be formed on the red subpixel SPr. Although not illustrated, the green organic emitting layer 122g, the green cathode electrode 123g, and the first inorganic insulating layer 135-1 may also be formed on the blue subpixel SPb.

The first inorganic insulating layer 135-1 may be composed of a double layer comprising a silicon oxide layer and a silicon nitride layer on the silicon oxide layer. For example, the silicon oxide layer may be formed using an ALD process, and the silicon nitride layer may be formed using a CVD process.

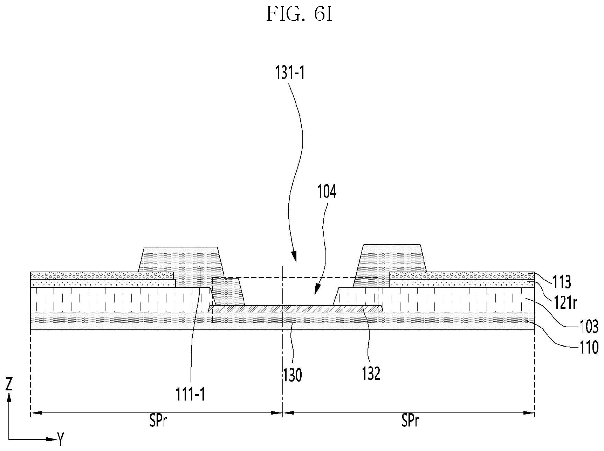

As illustrated in FIG. 6I, the green organic emitting layer 122g, the green cathode electrode 123g, and the first inorganic insulating layer 135-1 formed on a plurality of red subpixels SPr in the second direction Y may be removed. That is, the green organic light-emitting layer 122g, the green cathode electrode 123g, and the first inorganic insulating layer 135-1 may be formed only on the plurality of green subpixels SPg on the second direction Y and the plurality of auxiliary electrodes 132 between the plurality of green subpixels SPg.

Accordingly, the blocking layer 113 formed on the red subpixel SPr and the auxiliary electrode 132 formed on the first groove 131-1 of the first bank 111-1 may be exposed. Although not illustrated, the green organic light-emitting layer 122g, the green cathode electrode 123g, and the first inorganic insulating layer 135-1 formed on the blue subpixel SPb on the second direction Y may be removed. Accordingly, the green organic light-emitting layer 122g, the green cathode electrode 123g, and the first inorganic insulating layer 135-1 may be formed only on the auxiliary electrode 132 between the plurality of green subpixels SPg on the second direction Y, so that the plurality of green organic light-emitting elements 120g may be manufactured on the plurality of green subpixels SPg on the second direction Y, and the green cathode electrode 123g of the green organic light-emitting elements 120g may be electrically connected to the first power wiring PL1 through the connection structure 130.

At the step where the deposition of the green cathode electrode 123g is completed (FIG. 5I), the cross-sectional structure of the connection structure 130 of the red subpixel SPr may be illustrated in FIG. 6H.

Comparing the cross-sectional structures of the drawings illustrated in FIG. 5I and FIG. 6H, it may be seen that when the green organic light-emitting element 120g is formed on the red subpixel SPr, there is no undercut structure and no open structure on the red subpixel SPr.

Although not illustrated, at the step where the manufacturing of the green subpixel SPg is completed (FIG. 5K), an organic insulating layer may be formed on the red subpixel SPr and then removed again (same structure as FIG. 6H), and the first inorganic insulating layer 135-1 and the organic light-emitting elements 122g and 123g may be removed from the green subpixel SPg through a dry etching process.

Since the above-described process is performed in a state where the undercut structure is not formed (FIG. 6H), a residual film that may occur on the undercut structure may be fundamentally blocked.

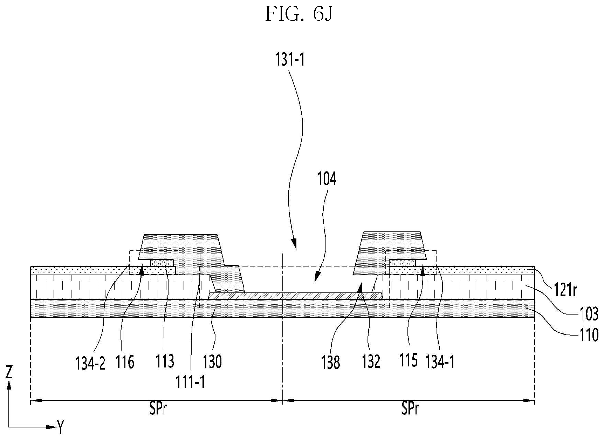

Meanwhile, an undercut structure, an open structure, etc. may be formed just before the red organic light-emitting element 120r is formed in the red subpixel SPr (FIG. 6J).

After the green organic light-emitting element 120g is manufactured, the red organic light-emitting element 120r may be manufactured as illustrated in FIGS. 6J to 6K. Although not illustrated, the blue organic light-emitting element 120b may be manufactured after the red organic light-emitting element 120r is manufactured. Thereafter, as illustrated in FIG. 5K, the organic insulating layer 141-4 and the fourth inorganic insulating layer 135-4 may be formed, so that an organic light-emitting display device according to an embodiment may be manufactured.

Hereinafter, a manufacturing process of the red organic light-emitting element 120r will be described with reference to FIGS. 6J to 6K.

As described above, the last process for completing the patterning of the green subpixel SPg is a step in which a connection structure, an open structure, etc. may be formed on the red subpixel SPr, and a separate photolithography process may be required to form the connection structure, the open structure, etc., but is not limited thereto.

As illustrated in FIG. 6J, a photosensitive pattern may be formed on the remaining region excluding the plurality of red subpixels SPr on the second direction Y, that is, on the plurality of green subpixels SPg on the second direction Y and the plurality of blue subpixels SPb on the second direction Y.

Thereafter, a wet etching process may be performed using the photosensitive pattern, so that the blocking layer 113 exposed to the plurality of red subpixels SPr and the blocking layer 113 positioned under the first bank 111-1 may be removed, so that undercut structures 115 and 116 may be formed. That is, a side portion of the blocking layer 113 may be recessed inwardly from an outer side portion of the first bank 111-1, so that open structures 134-1 and 134-2 having undercut structures 115 and 116 may be formed.

Subsequently, another etching process may be additionally performed, so that the interlayer-insulating layer 103 exposed to the first groove 131-1 of the first bank 111-1 may be recessed from a lower side of the first bank 111-1 toward a direction of an outer side to form an undercut structure 138. The connection structure 130 may also comprise the undercut structure 138 together with the auxiliary electrode 132, but is not limited thereto.

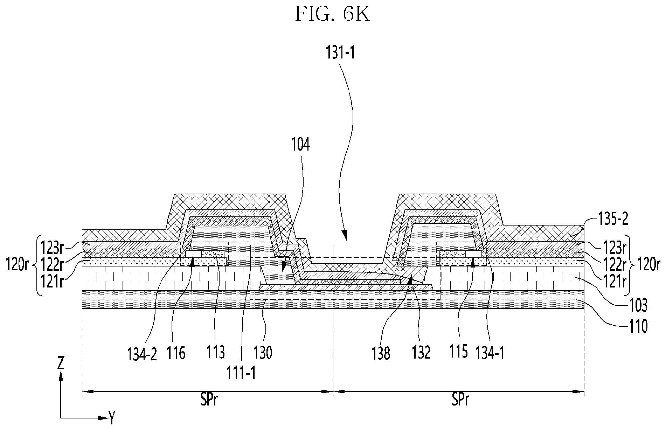

As illustrated in FIG. 6K, the red organic light-emitting layer 122r, the red cathode electrode 123r, and the second inorganic insulating layer 135-2 may be formed on the entire region of the substrate 110 or on the display region AA of the substrate 110. That is, the red organic light-emitting layer 122r, the red cathode electrode 123r, and the second inorganic insulating layer 135-2 may be formed on a plurality of red subpixels SPr, a plurality of green subpixels SPg, and a plurality of blue subpixels SPb.

The second inorganic insulating layer 135-2 may be composed of a double layer comprising a silicon oxide layer and a silicon nitride layer on the silicon oxide layer. For example, the silicon oxide layer may be formed using an ALD process, and the silicon nitride layer may be formed using a CVD process.

Thereafter, a photosensitive pattern may be formed on a plurality of red subpixels SPr in the second direction Y, and then an etching process may be performed using the photosensitive pattern.

Through the etching process, the remaining region except for the plurality of red subpixels SPr, that is, the red organic light-emitting layer 122r, the red cathode electrode 123r, and the second inorganic insulating layer 135-2 on the plurality of green subpixels SPg and the plurality of blue subpixels SPb, may be removed. Accordingly, the red organic light-emitting layer 122r, the red cathode electrode 123r, and the second inorganic insulating layer 135-2 may be formed only on the plurality of red subpixels SPr in the second direction Y, so that a plurality of red organic light-emitting elements 120r may be manufactured on the plurality of green subpixels SPg in the second direction Y.

Although not illustrated, a blue organic light-emitting element 120b may be manufactured through a process similar to the manufacturing process of the plurality of red organic light-emitting elements 120r. That is, a blue green light-emitting layer, a blue cathode electrode, and a third inorganic insulating layer 135-3 are laminated and patterned, so that a blue organic light-emitting element may be manufactured.

As described above, a green organic light-emitting element 120g, a red organic light-emitting element 120r, and a blue organic light-emitting element may be manufactured sequentially.

Thereafter, as illustrated in FIG. 5K, after the blue organic light-emitting element is manufactured, an organic insulating layer 141-4 may be formed in the entire region of the substrate 110 or the display region AA of the substrate 110, and a fourth inorganic insulating layer 135-4 may be formed on the organic insulating layer 141-4.

Although not illustrated, at least one or more inorganic insulating film may be formed under the organic insulating layer 141-4.

The organic insulating layer 141-4 may be formed using an inkjet process, but is not limited thereto. The fourth inorganic insulating layer 135-4 may be formed of an inorganic material such as silicon nitride (SiNx) using a PECVD process, but is not limited thereto.

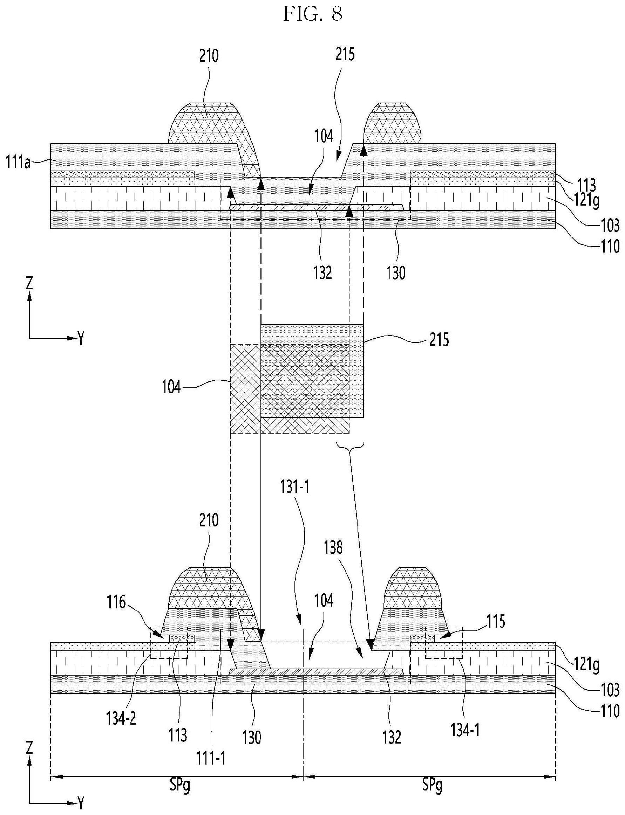

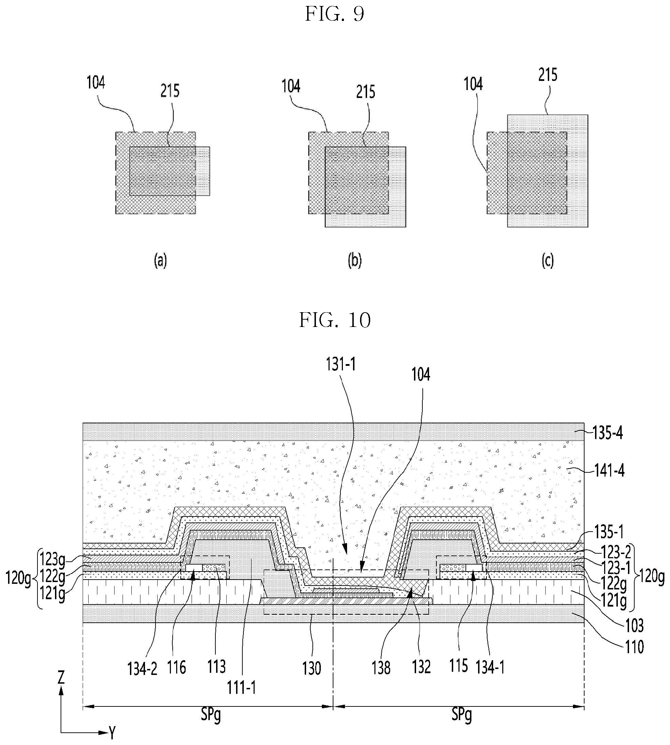

FIG. 7 illustrates a shape in which a groove of a photosensitive pattern is differently positioned relative to a groove of an interlayer-insulating layer along the second direction Y. FIG. 8 illustrates a positional relationship between a groove of an interlayer-insulating layer and a groove of a photosensitive pattern. FIG. 9 illustrates a shape in which a groove of a photosensitive pattern is disposed on different sides of a groove of an interlayer-insulating layer.

A plurality of undercut structures 138 may be differently positioned in a plurality of first grooves 131-1 of a plurality of first banks 111-1.

As illustrated in FIGS. 7 to 9, the placement positions of the plurality of undercut structures 138 may vary depending on the position of the groove of the first photosensitive pattern 210 relative to the first groove 104 of the interlayer-insulating layer 103.

For example, the first groove 104 of the interlayer-insulating layer 103 and the groove of the first photosensitive pattern 210 may each have a square shape when viewed from above, but is not limited thereto.

As illustrated in FIG. 7, in the connection structure 130 on the m-th row line, the groove of the first photosensitive pattern 210 relative to the first groove 104 of the interlayer-insulating layer 103 may be formed to deviate to the right and rear side. When the etching process is performed using the first photosensitive pattern 210, the undercut structure 138 may be formed under the first bank 111-1 on the right and rear side of the first groove 104.

In the connection structure 130 on the (m+1)-th row line, the groove of the first photosensitive pattern 210 may be formed to deviate to the rear and left side with respect to the first groove 104 of the interlayer-insulating layer 103. When the etching process is performed using the first photosensitive pattern 210, the undercut structure 138 may be formed under the first bank 111-1 on the rear and left side of the first groove 104.

In the connection structure 130 on the (m+2)-th row line, the groove of the first photosensitive pattern 210 may be formed to deviate to the left and front side with respect to the first groove 104 of the interlayer-insulating layer 103. When the etching process is performed using the first photosensitive pattern 210, the undercut structure 138 may be formed under the first bank 111-1 on the left and front side of the first groove 104.

In the connection structure 130 on the (m+3)-th row line, the groove of the first photosensitive pattern 210 may be formed to deviate from the front and right side with respect to the first groove 104 of the interlayer-insulating layer 103. When the etching process is performed using the first photosensitive pattern 210, the undercut structure 138 may be formed under the first bank 111-1 on the front and right side of the first groove 104.

The four connection structures illustrated on the left side of FIG. 7 will be described in detail. For example, as illustrated in FIGS. 7 to 9, among the four side portions of the first groove 104 and 131-1, two side portions may have the undercut structure 138 formed, and the remaining two side portions may not have the undercut structure 138 formed.

In the deposition apparatus, the organic light-emitting material may be evaporated in a certain direction and at a certain angle (FIG. 5I) by the angle limiting plate. In a region where the undercut structure 138 is formed, the organic light-emitting material may not be deposited in a part of the undercut structure due to the shadow effect, so that a part of the auxiliary electrode 132 may be exposed. In addition, in a region where the undercut structure 138 is not formed, the organic light-emitting material may be continuously connected without a break.

Therefore, the organic light-emitting material may be deposited within the same first groove 104 and 131-1 so that a part of the auxiliary electrode 132 remains exposed.

Thereafter, in the next deposition apparatus, the cathode electrode material may be deposited so as to contact a part of the exposed auxiliary electrode 132 in the undercut structure 138, and may be continuously connected without a break in a region where the undercut structure 138 is not formed.

Depending on the direction of progress of the substrate 110 during deposition and the angle and position of the evaporation source, at least one of the four connection structures 130 may be electrically connected to the green cathode electrode 123g and the auxiliary electrode 132 of the connection structure 130, thereby increasing reliability.

As illustrated in FIG. 5I, the green cathode electrode 123g may be electrically connected to the auxiliary electrode 132 of the connection structure 130 in the undercut structure 138.

In this way, the undercut structures 138 may be disposed differently from each other in the plurality of connection structures 130 on the plurality of row lines in the second direction Y. Accordingly, the green cathode electrode 123g disposed across the plurality of green subpixels SPg along the second direction Y may be electrically connected to different regions of the plurality of auxiliary electrodes 132 in the plurality of connection structures 130 on the plurality of row lines along the second direction Y.

For example, the green cathode electrode 123g may be electrically connected to the auxiliary electrode 132 on the right and rear side of the first groove 104 and 131-1 of the first bank 111-1 and the interlayer insulating layer 103 through the undercut structure 138 in the connection structure 130 on the m-th row line. For example, the green cathode electrode 123g may be electrically connected to the auxiliary electrode 132 on the rear and left sides of the first groove 104 and 131-1 of the interlayer insulating layer 103 through the undercut structure 138 on the (m+1)-th row line. For example, the green cathode electrode 123g may be electrically connected to the auxiliary electrode 132 on the left and front sides of the first groove 104 and 131-1 of the interlayer insulating layer 103 through the undercut structure 138 in the connection structure 130 on the (m+2)-th row line. For example, the green cathode electrode 123g may be electrically connected to the auxiliary electrode 132 on the front and right sides of the first groove 104 and 131-1 of the interlayer insulating layer 103 through the undercut structure 138 in the connection structure 130 on the (m+3)th row line.

Meanwhile, the groove of the first photosensitive pattern 210 with respect to the first groove 104 of the interlayer-insulating layer 103 may deviate to at least one or more side. For example, as illustrated in FIG. 9(a), the groove of the first photosensitive pattern 210 may be formed so as to deviate only to the left with respect to the first groove 104 of the interlayer-insulating layer 103. For example, as illustrated in FIG. 9(b), the groove of the first photosensitive pattern 210 may be formed so as to deviate to the right and rear side with respect to the first groove 104 of the interlayer-insulating layer 103. As illustrated in FIG. 9(c), the groove of the first photosensitive pattern 210 may be formed so as to deviate to the front, right, and rear with respect to the first groove 104 of the interlayer-insulating layer 103.

According to an embodiment, in the plurality of connection structures 130 on the plurality of row lines along the second direction Y, the plurality of undercut structures 138 may be formed to be positioned differently from each other in the plurality of first banks 111-1 and the first grooves 104 and 131-1 of the interlayer-insulating layer 103, so that the cathode electrodes may be formed on the plurality of auxiliary electrodes 132 of the plurality of connection structures 130 through the plurality of undercut structures 138 formed at different positions. Accordingly, electrical connection failure between the cathode electrodes and the first power wiring PL1 through the connection structures 130 can be prevented, so that light emission failure or operation failure can be prevented, and reliability can be improved.

FIG. 10 is a cross-sectional view illustrating an organic light-emitting display device according to a fourth embodiment. The fourth embodiment is the same as the first embodiment (FIG. 2) except for the green cathode electrode 123g formed as a double layer. In the fourth embodiment, the same drawing reference numerals are given to components having the same shape, structure, and/or function as those of the first embodiment (FIG. 2), and detailed descriptions thereof are omitted.

Although the drawing illustrates a plurality of green cathode electrodes 123g of a plurality of green subpixels SPg on the second direction Y, the same may be applied to a plurality of red cathode electrodes 123r of a plurality of red subpixels SPr on the second direction Y and/or a plurality of blue cathode electrodes of a plurality of blue subpixels SPb on the second direction Y.

Referring to FIGS. 1 and 10, an organic light-emitting display device according to the embodiment may comprise a first bank 111-1, a green organic light-emitting element 120g, a connection structure 130, etc.

The first bank 111-1 may be disposed between adjacent green subpixels SPg. A first groove 131-1 may be formed in the first bank 111-1, and an undercut structure 138 may be formed on the lower side of the first bank 111-1 in contact with the first groove 131-1.

The green organic light-emitting element 120g may comprise a green anode electrode 121g, a green organic light-emitting layer 122g, and a green cathode electrode 123g.

The green cathode electrode 123g may be electrically connected to the first power wiring PL1 through the connection structure 130. For example, the green cathode electrode 123g may be in contact with an upper surface of the auxiliary electrode 132 of the connection structure 130 in the undercut structure 138.

In an embodiment, the green cathode electrode 123g may comprise a first conductive layer 123-1 and a second conductive layer 123-2. The second conductive layer 123-2 may be disposed on the first conductive layer 123-1.

The first conductive layer 123-1 may comprise a material having excellent electrical conductivity, such as Mg:Ag. The first conductive layer 123-1 comprising Mg:Ag may not have good step coverage. When the first conductive layer 123-1 is deposited on the substrate 110, the first conductive layer 123-1 on the first home 131-1 and the first conductive layer 123-1 on the upper side of the first bank 111-1 may be separated without being connected to each other. In addition, the first conductive layer 123-1 in the first groove 131-1 may not be in contact with the upper surface of the auxiliary electrode 132 in the undercut structure 138. In this instance, since the first power wiring PL1 is disconnected from the green cathode electrode 123g on the green subpixel SPg through the connection structure 130, the green organic light-emitting element 120g on the green subpixel SPg does not operate or does not emit light, which may reduce the reliability of the product. In addition, when the first conductive layer 123-1 is formed with a very thin thickness of approximately 10 nm, the step coverage may not be good, which may result in increased resistance or disconnection.

To solve this problem, the second conductive layer 123-2 having excellent step coverage may be formed on the first conductive layer 123-1, so that a green cathode electrode 123g composed of the first conductive layer 123-1 and the second conductive layer 123-2 may be formed. The second conductive layer 123-2 may comprise a conductive oxide material having excellent step coverage, such as ITO.

Since the second conductive layer 123-2 has excellent step coverage, the second conductive layer 123-2 in the first groove 131-1 and the second conductive layer 123-2 on the upper side of the first bank 111-1 may be formed to be connected to each other without being disconnected. Since the second conductive layer 123-2 is formed in the undercut structure 138, the second conductive layer 123-2 may be in contact with the upper surface of the auxiliary electrode 132 in the undercut structure 138.

According to the embodiment, since the green cathode electrode 123g comprising the second conductive layer 123-2 with excellent step coverage as well as the first conductive layer 123-1 is provided, the connection failure between the green cathode electrode 123g and the connection structure 130 can be prevented, thereby increasing reliability.

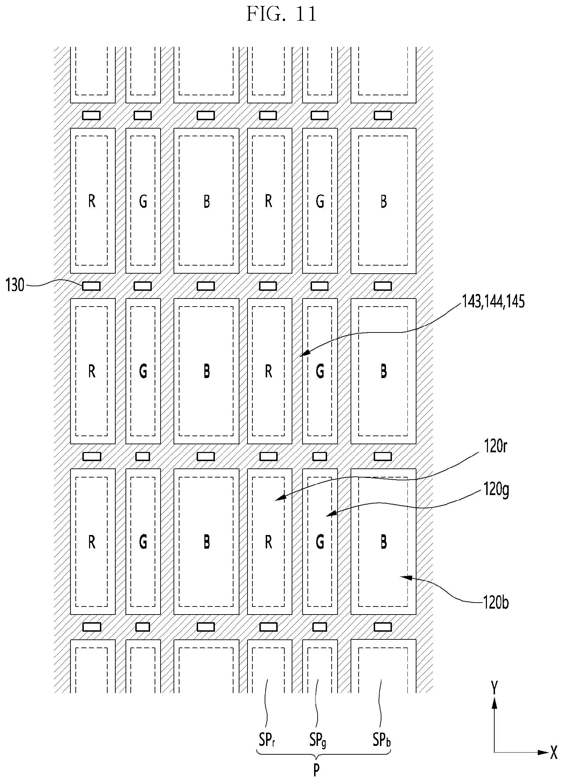

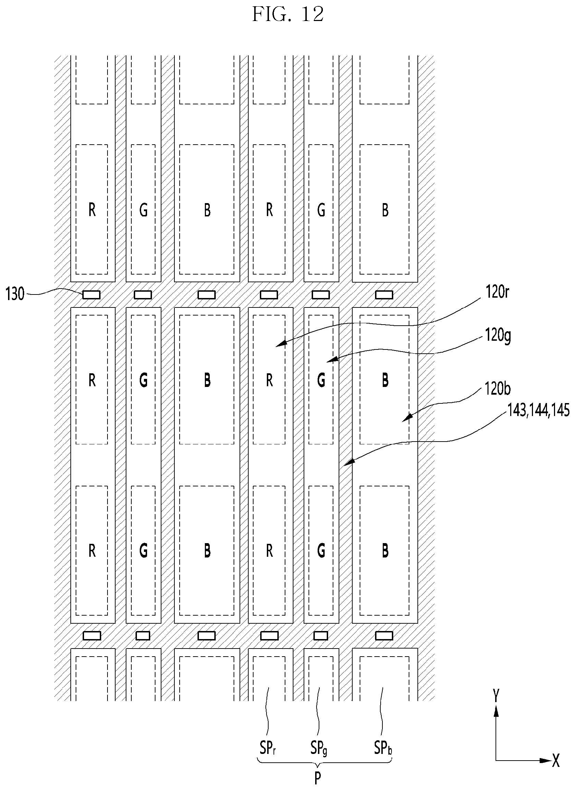

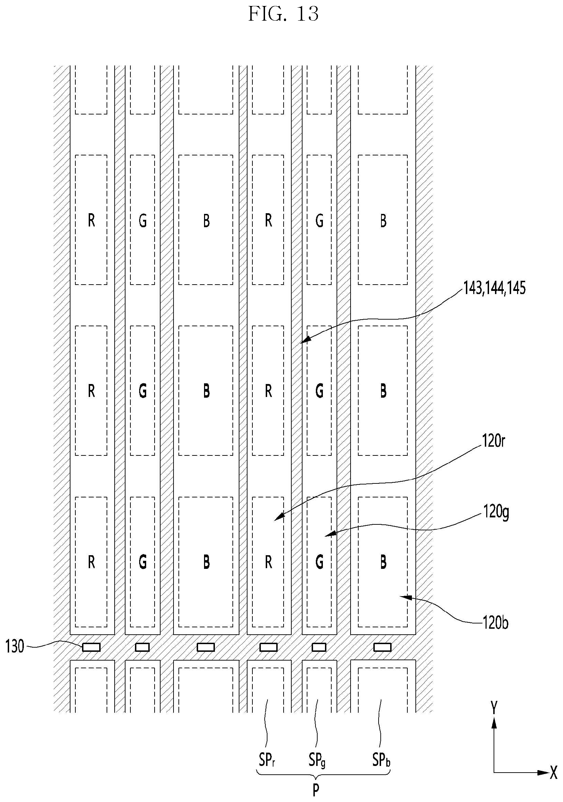

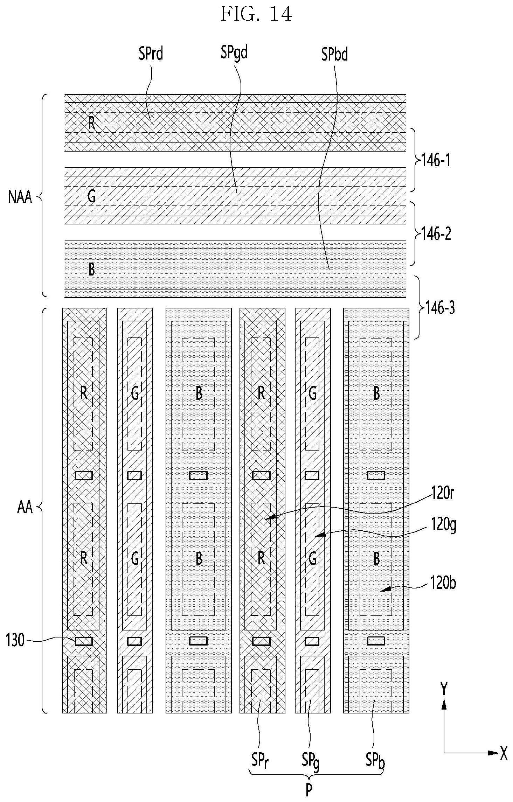

FIG. 11 illustrates a waterproof structure according to a first embodiment. FIG. 12 illustrates a waterproof structure according to a second embodiment. FIG. 13 illustrates a waterproof structure according to a third embodiment. FIG. 14 is a plan view schematically illustrating an organic light-emitting display device according to a second embodiment.

As illustrated in FIGS. 11 to 13, the waterproof structure may surround at least one or more subpixel among the plurality of subpixels SPr, SPg, and SPb in the second direction Y. Accordingly, the organic light-emitting element of at least one or more subpixel surrounded by the waterproof structure is not permeated by moisture, oxygen, etc., so that malfunction of the subpixel is prevented, thereby improving reliability.

For example, the connection structure 130 and the waterproof structure may be disposed between the plurality of subpixels SPr, SPg, and SPb in the second direction Y. For example, the waterproof structure may be disposed lengthwise along the first direction X between the plurality of subpixels SPr, SPg, and SPb in the second direction Y, and the connection structure 130 may be locally disposed in a region between the plurality of subpixels SPr, SPg, and SPb in the second direction Y. For example, the waterproof structure may also be formed in a region where the connection structure 130 is formed, but is not limited thereto.

For example, the waterproof structure may surround each of the plurality of subpixels SPr, SPg, and SPb along the second direction Y (FIG. 11).

For another example, the plurality of subpixels SPr, SPg, and SPb along the second direction Y may be grouped into two subpixel units, thereby defining a plurality of subpixel groups. In this instance, the waterproof structure may surround each of the plurality of subpixels groups (FIG. 12).

For another example, the plurality of subpixels SPr, SPg, and SPb along the second direction Y may be grouped into four subpixel units, thereby defining a plurality of subpixels groups. In this instance, the waterproof structure may surround each of the plurality of subpixels groups (FIG. 13).

FIG. 14 is a plan view schematically illustrating an organic light-emitting display device according to the second embodiment.

As illustrated in FIG. 14, a plurality of subpixels SPr, SPg, and SPb may be arranged in a stripe shape along a second direction Y on a display region AA, and a plurality of dummy subpixels SPrd, SPgd, and SPbd may be arranged in a stripe shape along a first direction X on a non-display region NAA. The non-display region NAA may comprise a bezel region.

A plurality of waterproof structures 146-1 to 146-3 may be disposed between the plurality of dummy subpixels SPrd, SPgd, and SPbd on the second direction Y.

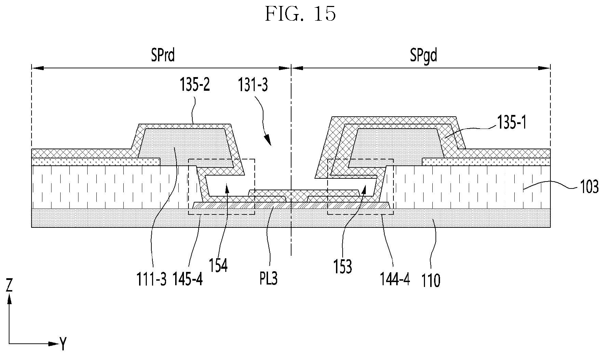

Meanwhile, since the non-display region NAA or the bezel region is a region where an image is not displayed, the red organic light-emitting element 120r, the green organic light-emitting element 120g, and the blue organic light-emitting element 120b may not be disposed. For example, as illustrated in FIG. 15, the red organic light-emitting element 120r may not be disposed in the red dummy subpixel SPrd, and the green organic light-emitting element 120g may not be disposed in the green dummy subpixel SPgd. That is, at least one or more of the anode electrode, the organic light-emitting layer, and the cathode electrode constituting the red organic light-emitting element 120r or the green organic light-emitting element 120g may not be disposed in the green dummy subpixel SPgd or the red dummy subpixel SPrd.

Although not illustrated, the blue organic light-emitting element 120b may not be disposed in the blue dummy subpixel SPbd.

A third bank 111-3 may be disposed between the red dummy subpixel SPrd and the red dummy subpixel SPrd, and the third groove 131-3 may be formed in the third bank 111-3. A plurality of undercut structures 153 and 154 may be formed on the lower side of the third bank 111-3 that contacts the third groove 131-3.

The plurality of waterproof structures 146-1 to 146-3 may each comprise two or more waterproof structures 144-4 and 145-4.

For example, the first waterproof structure 144-4 may be formed by a curved shape of the first inorganic insulating layer 135-1 disposed on the first undercut structure 153, and the second waterproof structure 145-4 may be formed by a curved shape of the second inorganic insulating layer 135-2 disposed on the second undercut structure 154.

The waterproof structures 144-4 and 145-4 may be identical to the second waterproof structure 144 and the third waterproof structure 145 illustrated in the third embodiment (FIG. 4).

In this way, by forming a plurality of waterproof structures 146-1 to 146-3 between a plurality of dummy subpixels SPrd, SPgd, and SPbd on the non-display region NAA, moisture, oxygen, etc. may be blocked from penetrating into the display region AA from the non-display region NAA. Even if moisture, oxygen, etc. penetrate from the non-display region NAA to the display region AA, moisture, oxygen, etc. may be blocked by the plurality of waterproof structures (143 to 145 in FIG. 4) formed lengthwise along the second direction Y between the plurality of subpixels SPr, SPg, and SPb in the first direction X in the display region AA, so that the moisture, oxygen, etc. do not penetrate into the plurality of organic light-emitting elements 120r, 120g, and 120b of the plurality of subpixels SPr, SPg, and SPb. Therefore, the performance of blocking penetration of moisture, oxygen, etc. can be dramatically improved, so that operation defects or light-emitting defects of the subpixels SPr, SPg, and SPb can be prevented, thereby increasing reliability.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. An organic light-emitting display device, comprising:
a plurality of subpixels having different colors along a first direction and having a same color along a second direction crossing the first direction;
a plurality of anode electrodes on the plurality of subpixels;
a plurality of organic light-emitting layers on the plurality of anode electrodes;
a plurality of cathode electrodes on the plurality of organic light-emitting layers;
a plurality of first banks between the plurality of subpixels along the second direction;
a plurality of first power wirings under the plurality of first banks along the first direction;
a plurality of connection structures disposed in a plurality of first grooves of some first banks among the plurality of first banks; and
a plurality of undercut structures on a lower side of some first banks that contact the plurality of first grooves,
wherein the organic light-emitting layer and the cathode electrode are disposed across some first banks, and
wherein the connection structure is configured to electrically connect the cathode electrode to the first power wiring in the undercut structure.

2. The organic light-emitting display device of claim 1, further comprising:
an interlayer-insulating layer under the first bank,
wherein the undercut structure is configured to be formed such that a side portion of the interlayer-insulating layer in contact with the first groove is recessed from an inner side portion of the first bank toward a direction of an outer side.

3. The organic light-emitting display device of claim 1, wherein the connection structure comprises an auxiliary electrode extended from the first power wiring,
wherein the organic light-emitting layer is configured to be cut off by the undercut structure so that some regions of the auxiliary electrode are exposed, and
wherein the cathode electrode is configured to be in contact with some regions of the exposed auxiliary electrode in the undercut structure.

4. The organic light-emitting display device of claim 1, comprising:
a plurality of inorganic insulating layers on the plurality of cathode electrodes;
a plurality of second banks having second grooves disposed lengthwise along the second direction between the plurality of subpixels in the first direction; and
a plurality of waterproof structures on the plurality of second banks, respectively.

5. The organic light-emitting display device of claim 4, wherein the plurality of waterproof structures comprises:
a first waterproof structure on the second bank;
a second waterproof structure on a first side of the second groove of the second bank; and
a third waterproof structure on a second side of the second groove of the second bank.

6. The organic light-emitting display device of claim 5, wherein the first waterproof structure is configured such that at least two of the plurality of inorganic insulating layers are overlapped on the second bank.

7. The organic light-emitting display device of claim 6, wherein the second waterproof structure is configured such that one of the plurality of inorganic insulating layers is formed in a curved shape by a first undercut structure,
wherein the third waterproof structure is configured such that another of the plurality of inorganic insulating layers is formed in a curved shape by a second undercut structure, and
wherein the first undercut structure and the second undercut structure are formed on a lower side of the second bank in contact with the second groove of the second bank.

8. The organic light-emitting display device of claim 4, wherein the waterproof structure is configured to surround at least one or more subpixel among the plurality of subpixels in the second direction.

9. The organic light-emitting display device of claim 1, further comprising:
a plurality of second power wirings in a plurality of second grooves of a plurality of second banks along the second direction,
wherein the at least two or more inorganic insulating layers are disposed on a second power wiring.

10. The organic light-emitting display device of claim 1, wherein the plurality of undercut structures are positioned differently from each other in the plurality of first grooves.

11. The organic light-emitting display device of claim 1, wherein the cathode electrode comprises:
a first conductive layer; and
a second conductive layer on the first conductive layer.

12. The organic light-emitting display device of claim 1, further comprising:
an open structure in an edge region of at least one or more of the first bank and a second bank,
wherein a hole injection layer or a charge generation layer of the organic light-emitting layer is cut off by the open structure.

13. The organic light-emitting display device of claim 1, further comprising:
a plurality of dummy subpixels having a stripe shape along the first direction in a non-display region; and
a plurality of waterproof structures between the plurality of dummy subpixels in the second direction.
